# EUROPEAN PATENT APPLICATION

(11) **EP 4 815 267 A1**
(43) Date of publication of application: **30.09.2026**
(21) Application number: 24893042.2
(22) Date of filing: 27.09.2024
(51) Int. Cl.: H02K 5/04, H02K 11/30, H02K 5/20, H02K 9/20, H02K 9/22, H02K 5/18, H02K 5/24, H05K 7/20, F04B 17/03, F04B 53/00, B60G 17/08, B60G 17/015, B60H 1/00, B60K 11/02

(54) **MOTOR ASSEMBLY, HYDRAULIC ENERGY SUPPLY DEVICE, CHASSIS SYSTEM AND VEHICLE**

(30) Priority: 23.11.2023 CN 202323183015 U
(71) Applicant: BYD Company Limited, Shenzhen, Guangdong 518118 (CN)
(72) Inventor: LI, Tianming, Shenzhen, Guangdong 518118 (CN); YU, Fengchuan, Shenzhen, Guangdong 518118 (CN); JIA, Xinglong, Shenzhen, Guangdong 518118 (CN); OU, Xiaoyan, Shenzhen, Guangdong 518118 (CN)
(74) Representative: Taor, Simon Edward William
(86) International application number: PCT/CN2024/121843
(87) International publication number: WO 2025/107883

(57) **Abstract**

The present disclosure provides a motor assembly (700), a hydraulic energy supply device (600), a chassis system, and a vehicle. The motor assembly (700) includes a motor controller (300) and a motor (120, 220). The motor (120, 220) is connected to an outer side of the motor controller (300). The motor (120, 220) includes a housing (121, 221). A flow channel (121₀, 221₀) is formed at a portion of the housing (121, 221) facing the motor controller (300). According to the present disclosure, the flow channel (121₀, 221₀) is formed in the portion of the housing (121, 221) of the motor (120, 220) facing the motor controller (300), which is conducive to dissipating heat from the motor controller (300), thereby improving operation efficiency of the motor controller (300).

## Description

The present disclosure claims priority to Chinese Patent Publication No. CN 202323183015.X, filed on November 23, 2023 and entitled "MOTOR ASSEMBLY, HYDRAULIC ENERGY SUPPLY DEVICE, CHASSIS SYSTEM, AND VEHICLE", which is incorporated herein by reference in its entirety.

### TECHNICAL FIELD

The present disclosure generally relates to the technical field of vehicles, and more specifically, to a motor assembly, a hydraulic energy supply device, a chassis system, and a vehicle.

### BACKGROUND

In a related technology, a motor assembly includes a motor and a motor controller. A cooling channel of the motor controller is generally disposed in an electronic control box, which is difficult to process.

### SUMMARY

A series of concepts in a simplified form are introduced to the SUMMARY, which are further described in detail in the DESCRIPTION OF EMBODIMENTS. The SUMMARY section of the present disclosure is not intended to define key features or essential technical features of claimed technical solutions, nor is it intended to limit the scope of protection of the claimed technical solutions.

To at least partially resolve foregoing problems, a first aspect of the present disclosure provides a motor assembly. The motor assembly includes a motor controller and a motor. The motor is connected to an outer side of the motor controller. The motor includes a housing. A flow channel is formed in a portion of the housing facing the motor controller.

In the motor assembly according to the first aspect of the present disclosure, a first flow channel is disposed at a portion of the motor close to the motor controller, and when a heat exchange medium circulates through the flow channel, the motor controller can be cooled, so that operation efficiency of the motor controller can be improved.

Optionally, the housing includes a housing body, a flow channel board, and a flow guide rib. A mounting groove is formed in a portion of the housing body facing the motor controller. The flow channel board is connected to the mounting groove to form a heat dissipation cavity. The flow channel board supports the motor controller. The flow guide rib is connected to the heat dissipation cavity, to define the heat dissipation cavity as the flow channel.

Optionally, the flow channel board includes an auxiliary heat dissipation body extending to the flow channel.

Optionally, the auxiliary heat dissipation body is configured to be a heat dissipation pin. The flow channel board includes a plurality of heat dissipation pins. The heat dissipation pins are spaced apart along an arrangement path adapted to the flow channel.

Optionally, the flow guide rib and the housing body are integrally formed.

Optionally, the motor assembly includes two motors. The two motors are arranged coaxially and oppositely. The housings of the two motors are connected to each other.

Optionally, the two housings are a first housing and a second housing respectively. A recessed platform is formed at an end portion of the first housing close to the second housing. A boss is formed at an end portion of the second housing close to the first housing. The boss is adapted to the recessed platform. The boss is welded and fixed to the recessed platform, to fix the second housing to the first housing.

Optionally, the two housings are an integrated component.

Optionally, an accommodating groove is formed in a joint of the two housings. A notch of the accommodating groove faces the motor controller. The accommodating groove is configured to at least accommodate a capacitor of the motor controller.

Optionally, the two housings are denoted as a first housing and a second housing respectively. A flow channel formed in the first housing is a first flow channel. A flow channel formed in the second housing is a second flow channel. The first flow channel and the second flow channel are spaced apart by the accommodating groove. The first flow channel and the second flow channel communicate with each other at a joint of the first housing and the second housing.

Optionally, the motor controller includes an electronic control housing and a breather valve. The electronic control housing is connected to the housing. The breather valve is connected to the electronic control housing. The breather valve communicates with the inside and the outside of the electronic control housing.

A second aspect of the present disclosure provides a hydraulic energy supply device for an active suspension. The hydraulic energy supply device includes the foregoing motor assembly.

In the hydraulic energy supply device according to the second aspect of the present disclosure, with application of the foregoing motor assembly, heat from the motor controller can be effectively dissipated, so that operation efficiency of the hydraulic energy supply device can be improved.

A third aspect of the present disclosure provides a hydraulic energy supply device. The hydraulic energy supply device further includes a first hydraulic pump, a second hydraulic pump, and a motor assembly. The motor assembly is the foregoing motor assembly. The two motors are respectively denoted as a first motor and a second motor. The first motor is connected to the first hydraulic pump and adapted to drive the first hydraulic pump. The second motor is connected to the second hydraulic pump and adapted to drive the second hydraulic pump.

In the hydraulic energy supply device according to the third aspect of the present disclosure, with application of the foregoing motor assembly, heat from the motor controller can be effectively dissipated, so that operation efficiency and power of the hydraulic energy supply device can be improved.

Optionally, the housings of the two motors are denoted as a first housing and a second housing respectively. The first housing and the second housing are connected to each other. The first hydraulic pump is disposed at an end portion of the first housing away from the second housing. The second hydraulic pump is disposed at an end portion of the second housing away from the first housing.

A fourth aspect of the present disclosure provides a chassis system. The chassis system includes a shock absorber and the foregoing hydraulic energy supply device. The hydraulic energy supply device is in fluid communication with the shock absorber.

In the chassis system according to the fourth aspect of the present disclosure, with application of the foregoing hydraulic energy supply device, damping effect of the chassis system can be improved.

A fifth aspect of the present disclosure provides a vehicle. The vehicle includes the foregoing motor assembly, or the foregoing hydraulic energy supply device, or the foregoing chassis system.

In the vehicle according to the fifth aspect of the present disclosure, application of the foregoing hydraulic energy supply device or the foregoing chassis system is conducive to improving stability of the vehicle and comfort of occupants during traveling.

Optionally, the motor assembly includes a first motor, a second motor, a first flow channel, and a second flow channel. The first flow channel is disposed on the first motor. The second flow channel is disposed on the second motor. The vehicle further includes an air conditioner. The air conditioner is in fluid communication with the first flow channel and/or the second flow channel.

### DESCRIPTION OF DRAWINGS

The following accompanying drawings of implementations of the present disclosure are included herein as part of the present disclosure for understanding of the present disclosure. Implementations of the present disclosure and descriptions thereof are shown in the accompanying drawings to explain principles of the present disclosure. In the accompanying drawings:
FIG. 1 is a perspective view of a hydraulic energy supply device according to a preferred implementation of the present disclosure;
FIG. 2 is an exploded perspective view of a first housing in FIG. 1;
FIG. 3 is another exploded perspective view of the first housing in FIG. 1;
FIG. 4 is an exploded perspective view of a second housing in FIG. 1;
FIG. 5 is another exploded perspective view of the second housing in FIG. 1;
FIG. 6 is an exploded perspective view of a first motor pump in FIG. 1;
FIG. 7 is an exploded perspective view of a second motor pump in FIG. 1;
FIG. 8 is a cross-sectional view of the hydraulic energy supply device in FIG. 1;
FIG. 9 is an enlarged view of portion I in FIG. 8;
FIG. 10 is an exploded perspective view of the hydraulic energy supply device shown in FIG. 1;
FIG. 11 is a perspective view of a hydraulic energy supply device according to another preferred implementation of the present disclosure;
FIG. 12 is an exploded perspective view of a first housing in FIG. 11;
FIG. 13 is another exploded perspective view of the first housing in FIG. 11;
FIG. 14 is an exploded perspective view of a second housing in FIG. 11;
FIG. 15 is another exploded perspective view of the second housing in FIG. 11;
FIG. 16 is an exploded perspective view of a first motor pump in FIG. 11;
FIG. 17 is an exploded perspective view of a second motor pump in FIG. 11;
FIG. 18 is a cross-sectional view of the hydraulic energy supply device shown in FIG. 11;
FIG. 19 is an exploded perspective view of the hydraulic energy supply device shown in FIG. 11;
FIG. 20 is a perspective view of a hydraulic energy supply device according to yet another preferred implementation of the present disclosure;
FIG. 21 is an exploded perspective view of an integrated housing and a flow channel board in FIG. 20;
FIG. 22 is another exploded perspective view of the integrated housing and the flow channel board in FIG. 20;
FIG. 23 is an exploded perspective view of the hydraulic energy supply device shown in FIG. 20;
FIG. 24 is a cross-sectional view of the hydraulic energy supply device shown in FIG. 20;
FIG. 25 is an exploded perspective view of the hydraulic energy supply device shown in FIG. 20;
FIG. 26 is a perspective view of a joint of a first electrical connecting member and a first motor body according to a preferred implementation of the present disclosure;
FIG. 27 is a perspective view of the joint of the first electrical connecting member and the first motor body in FIG. 26;
FIG. 28 is a diagram of a structure of the first electrical connecting member shown in FIG. 26 and FIG. 27;
FIG. 29 is a perspective view of a joint of a first electrical connecting member and a first motor body according to another preferred implementation of the present disclosure;
FIG. 30 is a diagram of a structure of the first electrical connecting member shown in FIG. 29;
FIG. 31 is an exploded perspective view of the first electrical connecting member shown in FIG. 29 and FIG. 30;
FIG. 32 is a diagram of a structure of a conical barrel shown in FIG. 29 to FIG. 31;
FIG. 33 is a perspective view of a joint of a first electrical connecting member and a first motor body according to yet another preferred implementation of the present disclosure; and
FIG. 34 is a perspective view of the first electrical connecting member shown in FIG. 33.

### Reference numerals:

| | | | |
|---|---|---|---|
| 100: | first motor pump | 110: | first hydraulic pump |
| 111: | first pump housing locating pin | 112: | first pump housing seal ring |
| 113: | first connecting hole | 114: | third connecting hole |
| 120: | first motor | 121: | first housing |
| 121a: | first housing body | 121b: | first mounting groove |
| 121c: | first flow guide rib | 121d: | first electronic control housing locating pin |
| 121e: | first via hole | 121g: | first wire hole |
| 121h: | first resolver via hole | 121i: | motor housing locating hole |
| 121j: | recessed platform | 121n: | first pump housing limiting hole |
| 121o: | first flow channel | 121p: | first opening |
| 121q: | second opening | 121r: | first partial groove |
| 121s: | second via hole | 121t: | first heat dissipation cavity |
| 122: | first heat sink | | |
| 123: | first heat pipe | 124: | first flow channel board |
| 124a | first auxiliary heat dissipation body | 125: | first motor body |
| 125a: | first motor body seal ring | 126: | first liquid connector |
| 127: | second liquid connector | 128: | first lead-out wire |
| 129: | first insulating seal member | 130: | first end cover assembly |
| 131: | first end cover | 131a: | first cantilever |
| 132: | first end cover seal ring | 140: | detection assembly |
| 141: | first seal ring | 142: | first temperature sensor |
| 143: | second temperature sensor | 144: | first adapter board |
| 145: | adapter post | 146: | second seal ring |
| 147: | fixing plate | 148: | second adapter board |
| 149: | adapter assembly | 150: | first resolver assembly |
| 151: | first resolver seal ring | 152: | first resolver snap spring |
| 153: | first resolver body | 160: | first electrical connecting member |
| 161: | first electrical connecting end | 161a: | first electrical terminal |
| 161b: | second electrical terminal | 161c: | third electrical terminal |
| 162: | protrusion | 162a: | first vacant portion |
| 162b: | first guide portion | 162c: | abutting portion |
| 162d: | second guide portion | 162e: | second vacant portion |
| 163: | conical barrel | 163a: | connecting hole |
| 163b: | first end | 163c: | second end |
| 163d: | groove | 164: | base portion |
| 164a | connecting groove | 165: | base portion |
| 166: | clamping portion | 166a: | locating groove |
| 167: | clamping opening | 168: | connecting plate |
| 168a: | first connecting plate | 168b: | second connecting plate |
| 168c | third connecting plate | 169: | second electrical connecting end |
| 169a | fourth electrical terminal | 169b: | fifth electrical terminal |
| 169c | sixth electrical terminal | 200: | second motor pump |
| 210: | second hydraulic pump | 211: | second pump housing locating pin |
| 212: | second pump housing seal ring | 213: | second connecting hole |
| 214: | fourth connecting hole | 220: | second motor |
| 221: | second housing | 221a: | second housing body |
| 221b: | second mounting groove | 221c: | second flow guide rib |
| 221d: | second electronic control housing locating pin | 221e: | third via hole |
| 221g: | second wire hole | 221h: | second resolver via hole |
| 221i: | Motor housing locating pin | 221j: | boss |
| 221n: | hole second pump housing limiting | 221o: | second flow channel |
| 221p: | third opening | 221q: | fourth opening |
| 221r: | second partial groove | 221s: | fourth via hole |
| 221t: | second heat dissipation cavity | | |
| 222: | second heat sink | 223: | second heat pipe |
| 224: | second flow channel board | 224a: | second auxiliary heat dissipation body |
| 225: | second motor body | 225a: | second pump body seal ring |
| 226: | third liquid connector | 227: | fourth liquid connector |
| 228: | second lead-out wire | 229: | second insulating seal member |
| 230: | second end cover assembly | 231: | second end cover |
| 231a | second cantilever | 232: | second end cover seal ring |
| 250: | second resolver assembly | 251: | second resolver seal ring |
| 252: | second resolver snap spring | 253: | second resolver body |
| 260: | member second electrical connecting | 300: | motor controller |
| 310: | electronic control housing | 320: | signal plug-in connector |
| 330: | bus electrical terminal | 340: | breather valve |
| 350: | shield plate | 360: | control circuit board |
| 370: | drive circuit board | 371: | power device |
| 372: | alternating current terminal | 373: | direct current terminal |
| 375: | capacitor | 376: | first power device |
| 377: | second power device | 400: | accommodating groove |
| 500: | housing | | |
| 500a | accommodating groove | 500c: | overflow groove |
| 500e | first mounting groove | 500f: | first flow guide rib |
| 500g: | first via hole | 500i: | first flow channel |
| 500j: | first liquid opening | 500k: | second liquid opening |
| 500m: | second mounting groove | 500n: | second flow guide rib |
| 500o: | third via hole | 500q: | second flow channel |
| 500r: | third liquid opening | 500s: | fourth liquid opening |
| 500t: | second via hole | 500u: | fourth via hole |
| 501: | overflow cover plate | 502: | flow channel board |
| 502a: | auxiliary heat dissipation body | 502b: | locating boss |
| 503: | first liquid connector | 504: | second liquid connector |
| 600: | hydraulic energy supply device | 700: | motor assembly |
| D1: | first direction | D2: | second direction, axial direction |
| D3: | third direction | DY1: | first extension direction |
| DY2: | second extension direction | DY3: | third extension direction |

### DETAILED DESCRIPTION OF EMBODIMENTS

In the following description, many specific details are given to provide a more thorough understanding of the present disclosure. However, it will be apparent to persons skilled in the art that implementations of the present disclosure can be implemented without one or more of these details. In other examples, to avoid confusion with implementations of the present disclosure, some technical features well-known in the art have not been described.

To provide a thorough understanding of the implementations of the present disclosure, detailed structures are set forth in the following description. Obviously, the implementations of the present disclosure are not limited to particular details familiar to persons skilled in the art.

It should be understood that the terms used herein are intended to describe specific implementations only and are not intended to limit the present disclosure, and the singular forms of "a", "an", and "the" are also intended to include plural forms, unless the context clearly indicates otherwise. When used in this specification, the terms "including" and/or "comprising" indicate the presence of said features, integers, steps, operations, elements and/or assemblies, but do not exclude the presence or attachment of one or more other features, integers, steps, operations, elements, assemblies, and/or combinations thereof.

Ordinal terms such as "first" and "second" as cited in the present disclosure are merely identifiers and do not have no other meaning, such as a specific order or the like. In addition, for example, the term "first component" does not imply presence of a "second component", and the term "second component" does not imply presence of a "first component". It should be noted that the terms "upper", "lower", "front", "rear", "left", "right", "inner", "outer", and similar expressions used in the present disclosure are merely for illustrative purposes only and are not limiting.

Hereinafter, specific implementations of the present disclosure will be described in more detail with reference to the accompanying drawings, which illustrate representative implementations of the present disclosure without limiting the present disclosure.

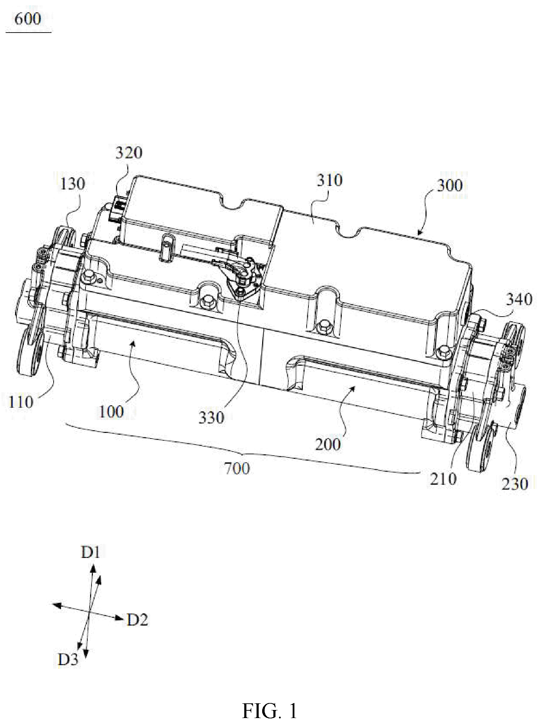

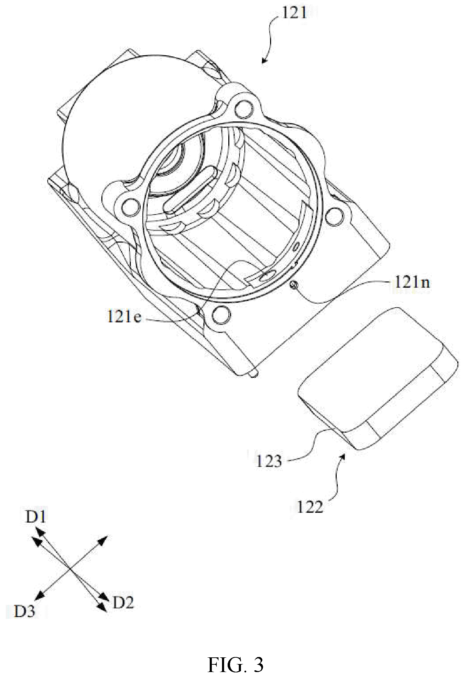

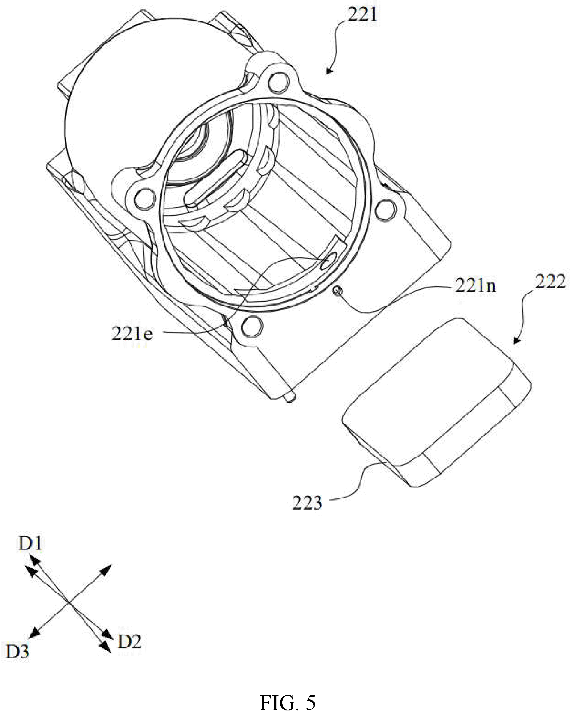

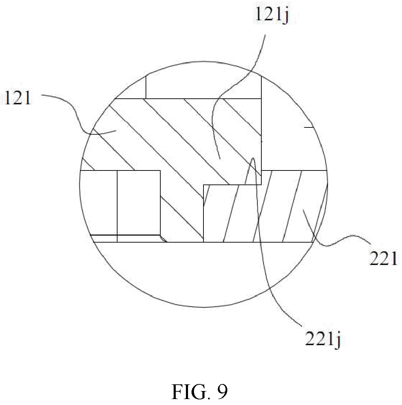

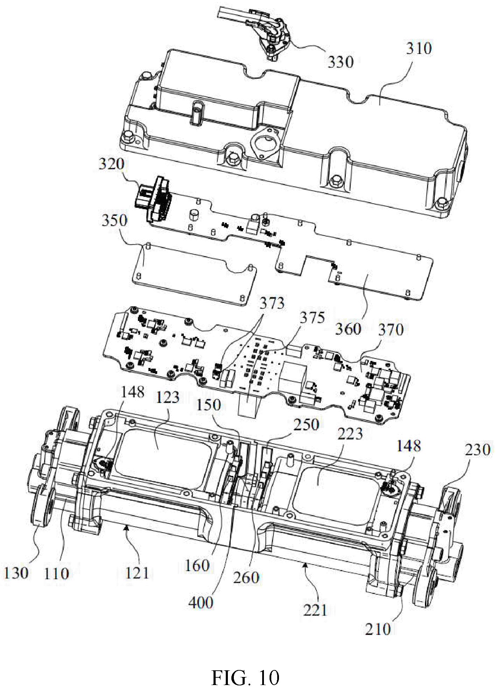

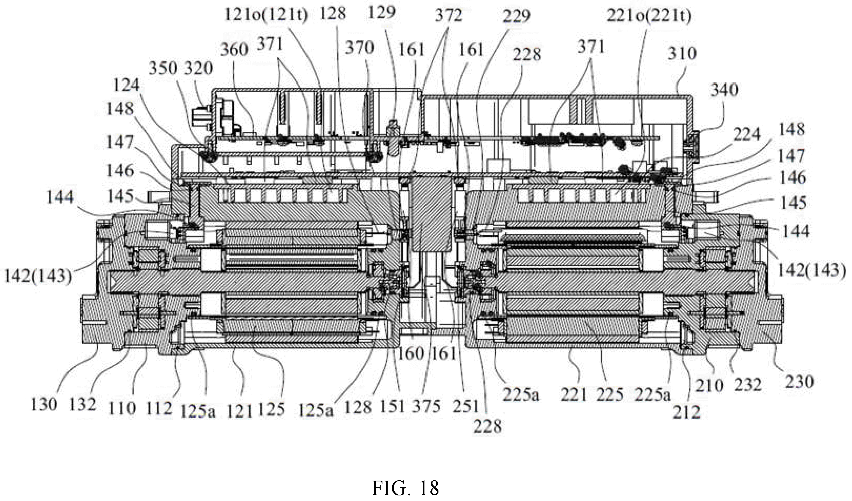

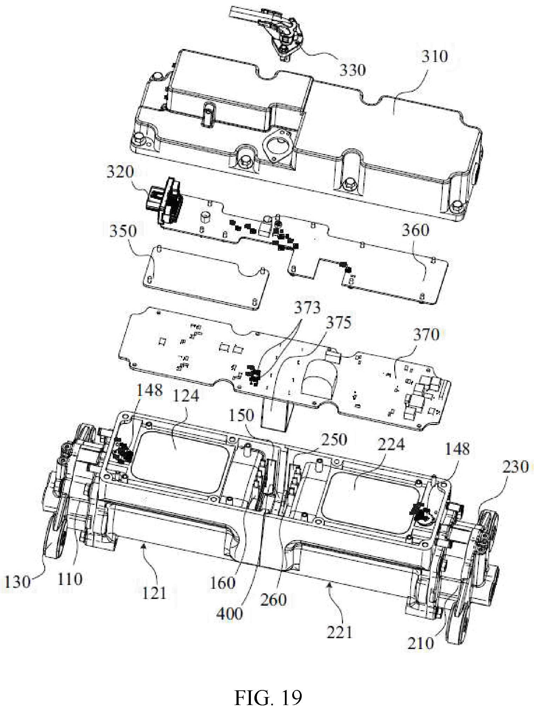

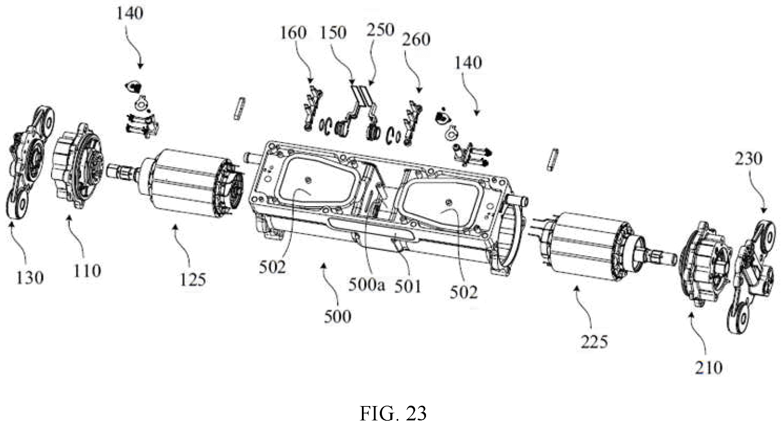

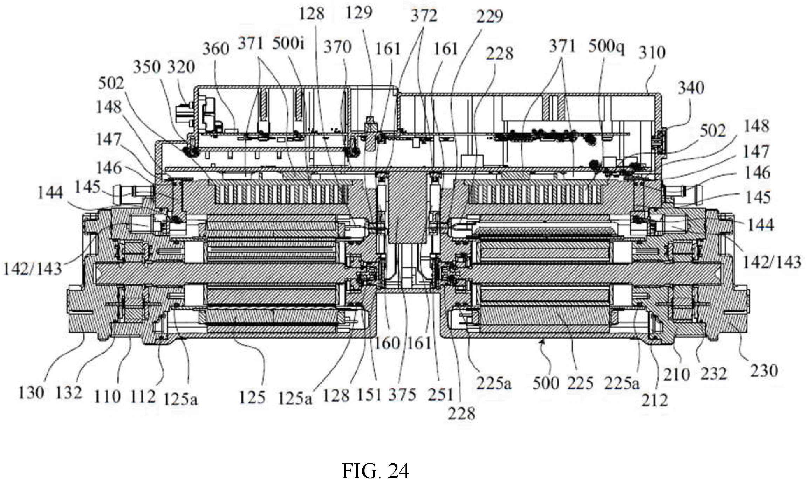

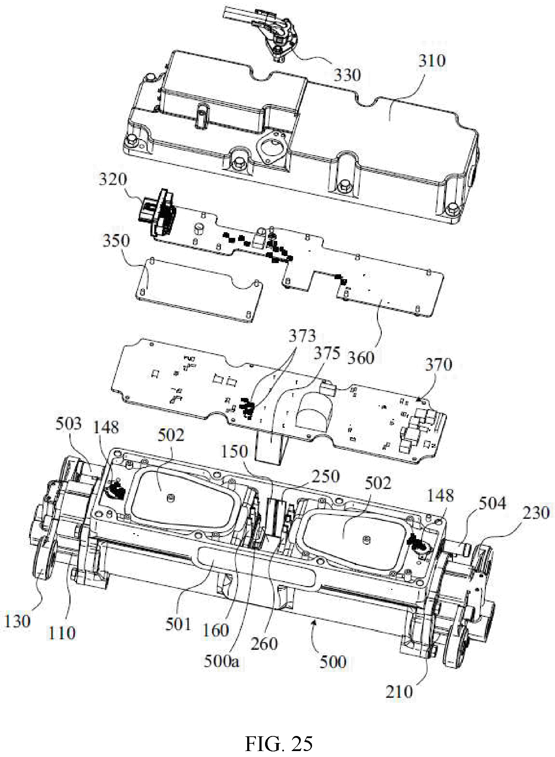

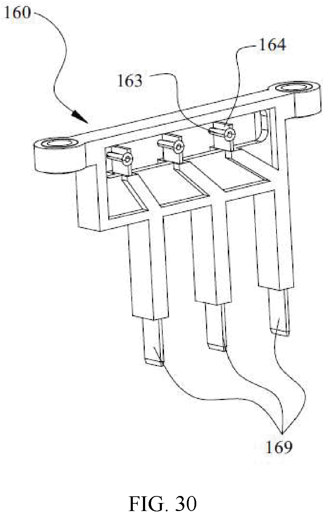

The present disclosure provides a hydraulic energy supply device 600. The hydraulic energy supply device 600 herein can be used in an active chassis system. The active chassis system can actively adjust a shock absorber based on different road conditions, thereby improving comfort and safety of a vehicle chassis. As shown in FIG. 1 to FIG. 34, the hydraulic energy supply device 600 according to the present disclosure may include a motor pump, a motor controller, and a heat sink. The motor pump may include a hydraulic pump and a motor for driving the hydraulic pump. Two motor pumps can form a motor pump set. Power of the motor pump set may be greater than 8 KW, for example, 9 KW. The motor and the motor controller may form a motor assembly 700. The motor may include a motor body and a housing. The motor body may include a stator and a rotor. The stator includes a stator winding and a stator core. The stator winding is connected to the stator core. The stator winding includes a winding body and a lead-out wire. The lead-out wire includes a root end and a tip end along a length direction of the lead-out wire, that is, two ends of the lead-out wire. The root end of the lead-out wire is connected to the winding body and fixed on the stator core. For example, the root end of the lead-out wire is wound around the stator core, or a busbar is disposed at an end of the winding connected to the lead-out wire. The lead-out wire is fixedly connected to the busbar. For example, a three-phase motor includes a three-phase winding and three lead-out wires corresponding to the three-phase winding. Each phase winding is connected to the busbar. The busbar is further connected to three lead-out wires. The three lead-out wires and the busbar may be formed as an integrated structure. The tip end of the lead-out wire is connected to a copper adapter busbar. The foregoing motor pump includes two motors. The two motors may be respectively denoted as a first motor 120 and a second motor 220. The first motor 120 includes a first winding body and a first lead-out wire 128. The second motor 220 includes a second winding body and a second lead-out wire 228. The motor controller 300 is disposed on an outer side of the motor in a first direction D1. When the hydraulic energy supply device 600 is mounted to a vehicle, the first direction D1 may be aligned with a height direction of the vehicle, and in this case, the motor controller 300 may be located above the motor. The heat sink is located between the motor and the motor controller, and is thermally connected to the motor and the motor controller. The heat sink is configured to conduct heat from the motor controller, thereby implementing an objective of cooling the motor controller.

In the hydraulic energy supply device 600 according to the present disclosure, the heat sink is disposed between the motor and the motor controller 300, so that heat from the motor and the motor controller 300 can be conducted, which is conducive to dissipating the heat from the motor controller 300, thereby improving operation efficiency of the motor controller 300.

Refer to FIG. 1 to FIG. 19. For example, a hydraulic energy supply device 600 according to the present disclosure may include a first motor pump 100, a motor controller 300, and a first heat sink 122. The first motor pump 100 may include a first hydraulic pump 110 and a first motor 120 configured to drive the first hydraulic pump 110. The motor controller 300 is disposed on an outer side of the first motor 120 in the first direction D1. When the hydraulic energy supply device 600 is mounted to a vehicle, the first direction D1 may be aligned with a height direction of the vehicle. In this case, the motor controller 300 may be located above the first motor 120. The motor controller 300 may alternatively be disposed on a side of the motor in a length direction of a vehicle body. For example, when the motor controller 300 is mounted on a front axle, the motor controller 300 may be located on a rear side of the first motor 120. When the motor controller 300 is mounted on a rear axle, the motor controller 300 may be located on a front side of the first motor 120. With this arrangement, the first direction D1 changes accordingly. In subsequent description, the present disclosure continues to describe by using the first direction D1 as the height direction of the vehicle body, but D1 may alternatively be the length direction. When the direction defined by D1 changes, other directions with reference to D1 are adjusted accordingly. The first heat sink 122 is located between the first motor 120 and the motor controller 300, and is thermally connected to the first motor 120 and the motor controller 300. The first heat sink 122 is configured to conduct heat from the first motor 120 and the motor controller 300. The first heat sink is disposed between the first motor and the motor controller 300, so that heat from the first motor and the motor controller 300 can be conducted, which is conducive to dissipating heat from the motor controller 300, thereby improving operation efficiency of the motor controller 300.

Continue to refer to FIG. 1 to FIG. 19. In addition, the hydraulic energy supply device 600 may further include a second motor pump 200 and a second heat sink 222. The second motor pump 200 and the first motor pump 100 are sequentially arranged in a second direction D2. The second direction D2 is parallel to an axis of the first motor 120. The axis of the first motor 120 herein may be understood as a rotation axis of a rotor of the first motor 120, or may be understood as an axis of the rotor of the first motor 120. That is, the first motor pump 100 and the second motor pump 200 are arranged coaxially and oppositely. The relative arrangement herein may be understood as that the first motor 120 and the second motor 220 are sequentially arranged with opposite orientations. For example, output ends of the first motor 120 and the second motor 220 respectively face sides away from each other, or are disposed close to each other. The two motors are not sequentially arranged with a same orientation. In an embodiment of the present disclosure, the output ends of the two motors are respectively disposed at two ends of the motor assembly 700 in the second direction D2 (namely an axial direction). When this arrangement is applied to a motor-pump assembly, the two motors are disposed oppositely, thereby enabling the two motors to share the motor controller 300, and facilitating an output configuration of the hydraulic pump. The second motor pump 200 may include a second hydraulic pump 210 and a second motor 220 configured to drive the second hydraulic pump 210. The first motor 120 is connected to the second motor 220. The motor controller 300 is located on an outer side of the second motor 220 in the first direction D1. The second heat sink 222 is located between the second motor 220 and the motor controller 300, and is thermally connected to the second motor 220 and the motor controller 300. The second heat sink 222 is configured to conduct heat from the second motor 220 and the motor controller 300. In this embodiment, the hydraulic energy supply device 600 includes two motor pumps, and the two motor pumps are controlled through the motor controller 300. The first heat sink 122 is disposed between the motor controller 300 and the first motor 120, and the second heat sink 222 is disposed between the motor controller 300 and the second motor 220, so that heat from portions that are of the motor controller 300 and that respectively correspond to the first motor 120 and the second motor 220 can be dissipated. This arrangement can improve heat dissipation effect of the motor controller 300, thereby improving operation efficiency and operation stability of the motor controller 300.

Optionally, there may be one or two motor controllers. When there is one motor controller, electrical elements and/or devices located in the motor controller may be integrated on a corresponding circuit board, or two integrated circuit boards with same functions may be provided. When there are two motor controllers, the two motor controllers are each provided with an integrated circuit board, and the two integrated circuit board may be the same.

Refer to FIG. 1 to FIG. 10. There are two heat sinks. The two heat sinks are respectively denoted as a first heat sink 122 and a second heat sink 222.

Continue to refer to FIG. 1 to FIG. 10. In an example, the first heat sink 122 is a first heat pipe 123. The first heat pipe 123 herein may include a closed housing and a heat-conducting medium sealed in the housing. The heat-conducting medium is heated and gasified such that the first heat pipe 123 can absorb external heat, to implement cooling effect. The heat-conducting medium is cooled and liquefied such that the first heat pipe 123 can release heat to the outside, to implement heat release effect. In this embodiment, the first heat pipe 123 may absorb heat from the motor controller 300 and transfer the heat to the first motor 120. Because the first motor 120 is connected to the first hydraulic pump 110, a portion of a hydraulic circuit is also disposed in the first motor 120, so that heat can be taken away by the hydraulic circuit. The hydraulic circuit is then cooled by other evaporative cooling methods. The first heat pipe 123 herein may be manufactured and implemented with reference to a mechanism of a heat pipe in an existing technology. The first heat pipe 123 may be of any outer shape, such as a square, a circle, or a polygon, and may be a regular shape or an irregular shape. Accordingly, the second heat sink 222 may be a second heat pipe 223. The second heat pipe 223 herein may include a closed housing and a heat-conducting medium sealed in the housing. The heat-conducting medium is heated and gasified such that the second heat pipe 223 can absorb external heat, to implement cooling effect. The heat-conducting medium is cooled and liquefied such that the second heat pipe 223 can release heat to the outside, to implement heat release effect. In this embodiment, the second heat pipe 223 may absorb heat from the motor controller 300 and transfer the heat to the second motor 220. Because the second motor 220 is connected to the second hydraulic pump 210, a portion of a hydraulic circuit is also disposed in the second motor 220, so that heat can be taken away by the hydraulic circuit. The hydraulic circuit is then cooled by other evaporative cooling methods. The second heat pipe 223 herein may be manufactured and implemented with reference to a mechanism of a heat pipe in an existing technology. The second heat pipe 223 may be of any outer shape, such as a square, a circle, or a polygon, and may be a regular shape or an irregular shape.

Refer to FIG. 1 to FIG. 10. Further, the first motor 120 may include a first housing 121. The first heat pipe 123 is disposed in the first housing 121. In this arrangement, a groove may be disposed in the first housing 121, and the first heat pipe 123 is installed in the groove. This facilitates separate manufacturing of the first heat pipe 123 and the first housing 121. Accordingly, the second motor 220 may include a second housing 221. The second heat pipe 223 is disposed in the second housing 221. In this arrangement, a groove may be disposed in the second housing 221, and the second heat pipe 223 is installed in the groove. This facilitates separate manufacturing of the second heat pipe 223 and the second housing 221. The first housing 121 is connected to the second housing 221 to form a common housing. The common housing is an undetachable housing.

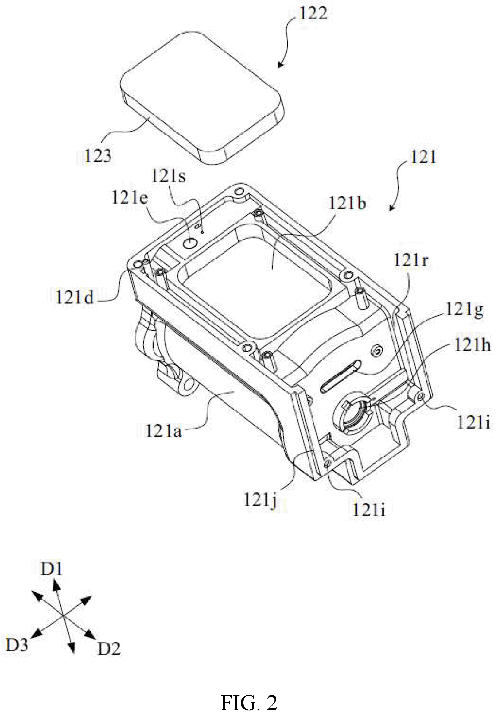

As shown in FIG. 2, FIG. 3, FIG. 6, FIG. 8, and FIG. 10, the first housing 121 is provided with a first heat pipe 123 and a groove for assembling the first heat pipe 123. Because the heat pipe has good thermal conductivity, adding the first heat pipe 123 may better dissipate heat from a power device 371 of the motor controller 300. The power device 371 may be connected to the first heat pipe 123 by using a heat-conducting medium such as heat-conducting silicone grease or a heat-conducting structure. The first housing 121 is further provided with a first electronic control housing locating pin 121d, which is configured to fit with a locating hole (not shown) of the electronic control housing 310 for position limitation. The first housing 121 is further provided with a motor housing locating hole 121i, which is configured to provide position limitation when the first housing 121 is assembled with the second housing 221. The first housing 121 is further provided with a first via hole 121e for mounting a temperature sensor. The first housing 121 is further provided with a recessed platform 121j, which may be configured to closely fit with the boss 221j of the second housing 221, to implement friction welding.

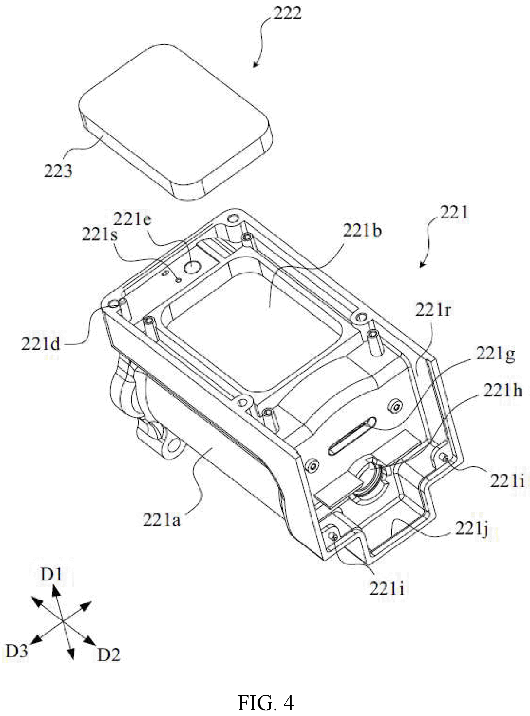

As shown in FIG. 4, FIG. 5, FIG. 7, and FIG. 10, the second housing 221 is provided with a second heat pipe 223 and a groove for assembling the heat pipe. Because the heat pipe has good thermal conductivity, adding the second heat pipe 223 may better dissipate heat from a power device 371 of the motor controller 300. The power device 371 may be connected to the second heat pipe 223 by using a heat-conducting medium such as heat-conducting silicone grease or a heat-conducting structure. The second housing 221 is further provided with a second electronic control housing locating pin 221d, which is configured to fit with a locating hole (not shown) of the electronic control housing 310 for position limitation. The second housing 221 is further provided with a motor housing locating hole 121i, which is configured to provide position limitation when the second housing 221 is assembled with the first housing 221. The second housing 221 is further provided with a third via hole 221e for mounting a second temperature sensor. The second housing 221 is further provided with a boss 221j, which may be configured to closely fit with the recessed platform 121j of the first housing 121, to implement friction welding.

Refer to FIG. 1, FIG. 8, and FIG. 10. For example, the motor controller 300 may include an electronic control housing 310. The electronic control housing 310 is connected to the first housing 121 and the second housing 221. The first heat sink 122 is located between the electronic control housing 310 and the first housing 121. The second heat sink 222 is located between the electronic control housing 310 and the second housing 221.

Refer to FIG. 2 to FIG. 10. Further, an accommodating groove 400 is formed in a joint of the first housing 121 and the second housing 221. Specifically, the first motor 120 includes a first motor body (not labeled). The first motor body and the second motor body each include a stator and a rotor. The stator includes a stator winding and a stator core. The second motor 220 includes a second motor body (not labeled). An accommodating groove 400 is disposed between the first motor body and the second motor body. The accommodating groove 400 is formed in the first housing 121 and the second housing 221. A notch of the accommodating groove 400 faces the motor controller 300. The accommodating groove 400 may be configured to at least accommodate electrical elements or devices such as a capacitor 375 of the motor controller 300. The capacitor 375 may be connected to a power device 371 corresponding to the first heat pipe 123 and connected to a power device 371 corresponding to the second heat pipe 223. This arrangement is conducive to integrating the motor controllers 300 of the two motors, enabling the two power devices 371 to share the capacitor 375, thereby improving an integration degree of the motor controller 300.

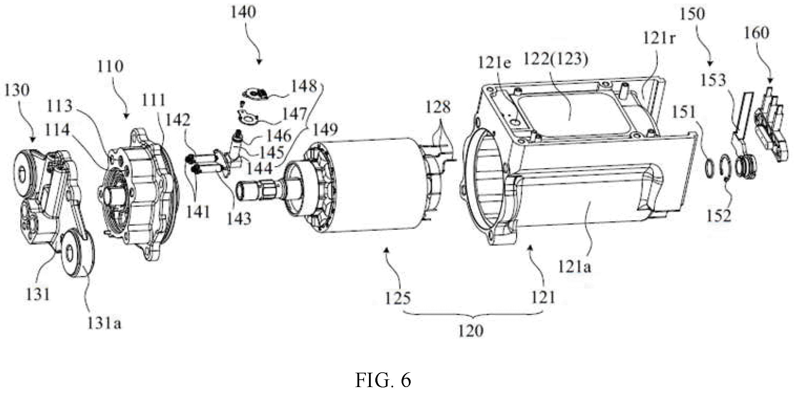

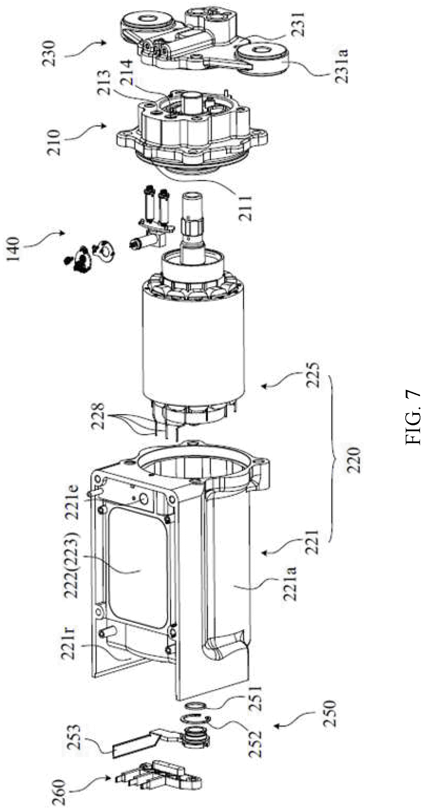

Further, at an end portion of the first housing body 121a of the first housing 121 facing the second housing 221 is recessed to form a first partial groove 121r (as shown in FIG. 2 and FIG. 6). An end portion of the second housing body 221a of the second housing 221 facing the first housing 121 is recessed to form a second partial groove 221r (as shown in FIG. 4 and FIG. 7). Upon assembly of the first housing 121 and the second housing 221, the first partial groove 121r and the second partial groove 221r form an accommodating groove 400. A position of the accommodating groove 400 herein relative to the first motor and the second motor, as well as functions implemented may be the same as that of the accommodating groove 500a below.

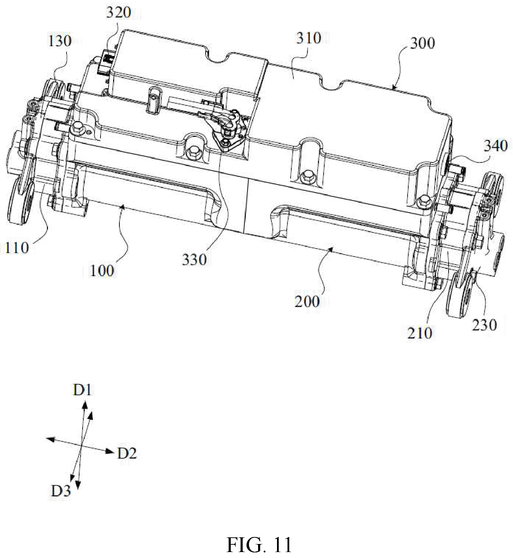

Refer to FIG. 11 to FIG. 19. In another example, the first motor 120 may include a first housing 121. The first heat sink 122 is formed in the first housing 121. A first flow channel 121o is formed in the heat sink. The first flow channel 121o is configured to circulate a heat exchange medium. Heat generated by the motor controller 300 can be exchanged through the heat exchange medium, so that effect of dissipating heat from and cooling the motor controller 300 can be achieved. The heat exchange medium in the first flow channel 121o may exchange heat with other portions of a heat exchange circuit, to cool the heat exchange medium. Accordingly, the second motor 220 may include a second housing 221. The second heat sink 222 is formed in the second housing 221. A second flow channel 221o is formed in the second heat sink 222. The second flow channel 221o is configured to circulate a heat exchange medium. Heat generated by the motor controller 300 can be exchanged through the heat exchange medium, so that effect of dissipating heat from and cooling can be achieved. The heat exchange medium in the second flow channel 221o may exchange heat with other portions of the heat exchange circuit, to cool the heat exchange medium.

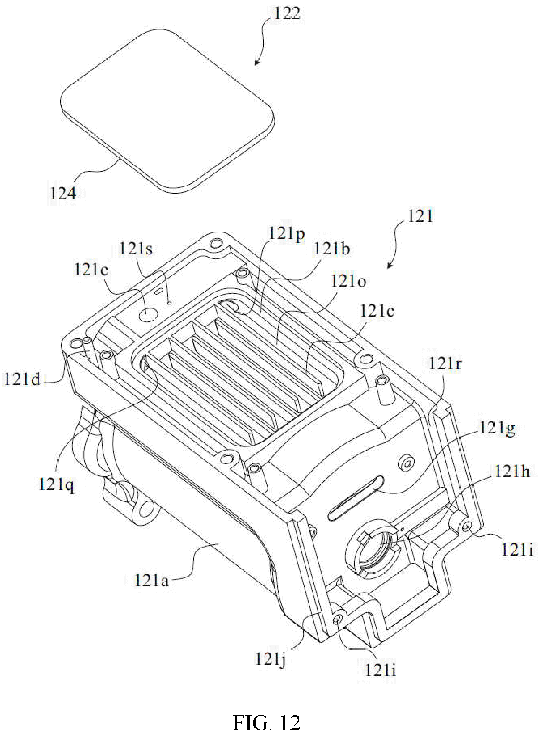

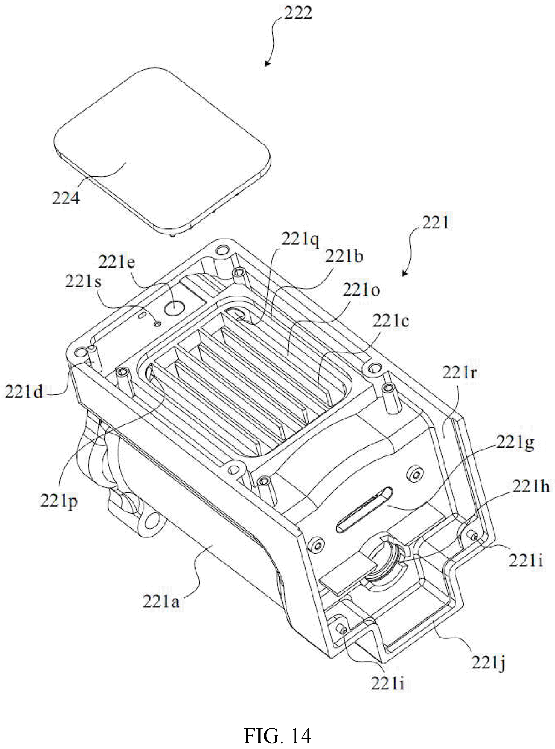

Refer to FIG. 12 and FIG. 14. Illustratively, the first flow channel 121o is arranged in a circuitous shape. The first flow channel 121o is disposed in a circuitous shape or a meandering shape, which is conducive to increasing a residence time of the heat exchange medium in the first flow channel 121o, thereby more fully exchanging heat with the motor controller 300, to achieve better heat dissipation effect. The circuitous shape herein is not limited to a form shown in the figures, and may take any other form capable of increasing an extended length of the first flow channel 121o in a region of a same size. Accordingly, the second flow channel 221o is arranged in a circuitous shape. The second flow channel 221o is disposed in a circuitous shape or a meandering shape, which is conducive to increasing a residence time of the heat exchange medium in the second flow channel 221o, thereby more fully exchanging heat with the motor controller 300, to achieve better heat dissipation effect. The circuitous shape herein is not limited to a form shown in the figures, and may take any other form capable of increasing an extended length of the second flow channel 221o in a region of a same size.

Refer to FIG. 12 to FIG. 19. Further, the first housing 121 may include a first housing body 121a, a first flow channel board 124, and a first flow guide rib 121c. A first mounting groove 121b is formed at a portion of the first housing body 121a facing the motor controller 300. The first flow channel board 124 is connected to the first mounting groove 121b to close a notch of the first mounting groove 121b to form a first heat dissipation cavity 121t. That is, the first flow channel board 124 covers the first mounting groove 121b, and the first heat dissipation cavity 121t is enclosed by the first flow channel board 124 and the first housing body 121a. The first heat dissipation cavity 121t can accommodate a heat exchange medium. The first flow channel board 124 supports the motor controller 300, thereby enabling heat absorption from the motor controller 300, and improving heat exchange efficiency. The first flow guide rib 121c is connected to the first heat dissipation cavity 121t, to define the first heat dissipation cavity 121t as a first flow channel 121o. The first flow guide rib 121c is disposed in the first heat dissipation cavity 121t, so that the foregoing first flow channel 121o is defined in the first heat dissipation cavity 121t. Briefly, the first flow channel 121o is enclosed by an inner surface of the first mounting groove 121b, the first flow guide rib 121c, and the first flow channel board 124. Accordingly, the second housing 221 may include a second housing body 221a, a second flow channel board 224, and a second flow guide rib 221c. A second mounting groove 221b is formed at a portion of the second housing body 221a facing the motor controller 300. The second flow channel board 224 is connected to the second mounting groove 221b to close a notch of the second mounting groove 221b to form a second heat dissipation cavity 221t. That is, the second flow channel board 224 covers the second mounting groove 221b, and the second heat dissipation cavity 221t is enclosed by the second flow channel board 224 and the second housing body 221a. The second heat dissipation cavity 221t can accommodate a heat exchange medium. The second flow channel board 224 supports the motor controller 300, thereby enabling heat absorption from the motor controller 300, and improving heat exchange efficiency. The second flow guide rib 221c is connected to the second heat dissipation cavity 221t, to define the second heat dissipation cavity 221t as a second flow channel 221o. The second flow guide rib 221c is disposed in the second heat dissipation cavity 221t, so that the foregoing second flow channel 221o is defined in the second heat dissipation cavity 221t. Briefly, the second flow channel 221o is enclosed by an inner surface of the second mounting groove 221b, the second flow guide rib 221c, and the second flow channel board 224.

Further, refer to FIG. 12, FIG. 13, FIG. 16, FIG. 18, and FIG. 19. The first flow channel board 124 may include a first auxiliary heat dissipation body 124a extending to the first flow channel 121o. With arrangement of the first auxiliary heat dissipation body 124a on the first flow channel board 124, a contact area between the heat exchange media in the first flow channel board 124 and the first flow channel board 124 can be increased, thereby further improving heat exchange efficiency. Accordingly, refer to FIG. 14, FIG. 15, and FIG. 17 to FIG. 19. The second flow channel board 224 may include a second auxiliary heat dissipation body 224a extending to the second flow channel 221o. With arrangement of the second auxiliary heat dissipation body 224a on the second flow channel board 224, a contact area between the heat exchange media in the second flow channel board 224 and the second flow channel board 224 can be increased, thereby further improving heat exchange efficiency.

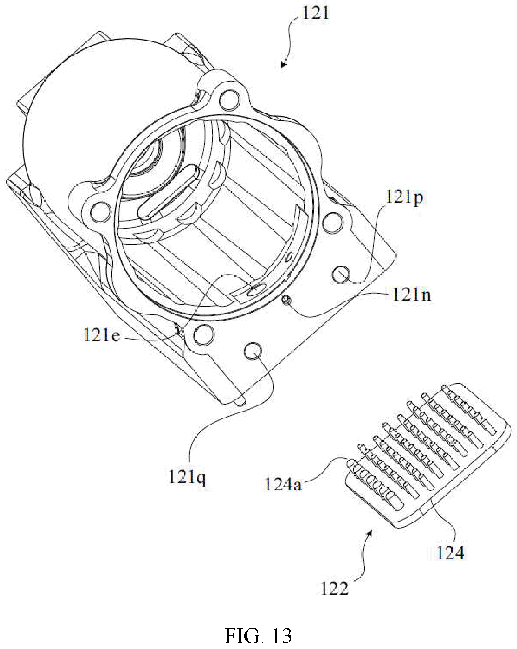

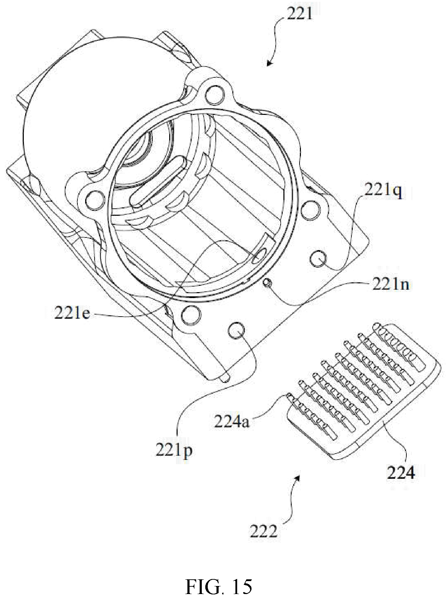

Specifically, as shown in FIG. 13, the first auxiliary heat dissipation body 124a may be configured to be a first heat dissipation pin. The first heat dissipation pin extends in a depth direction of the first mounting groove 121b. The first flow channel board 124 may include a plurality of first heat dissipation pins. The first heat dissipation pins are spaced apart along an arrangement path adapted to the first flow channel 121o. That is, when the first flow channel board 124 covers the notch of the first mounting groove 121b, the first heat dissipation pin is located in the first flow channel 121o, and the first heat dissipation pins and the first flow guide rib 121c are staggered from each other. Accordingly, as shown in FIG. 15, the second auxiliary heat dissipation body 224a may be configured to be a second heat dissipation pin. The second heat dissipation pin extends in a depth direction of the second mounting groove 221b. The second flow channel board 224 may include a plurality of second heat dissipation pins. The second heat dissipation pins are spaced apart along an arrangement path adapted to the second flow channel 221o. That is, when the second flow channel board 224 covers the notch of the second mounting groove 221b, the second heat dissipation pin is located in the second flow channel 221o, and the second heat dissipation pins and the second flow guide rib 221c are staggered from each other.

Refer to FIG. 11, FIG. 18, and FIG. 19. For example, the motor controller 300 may include an electronic control housing 310. The electronic control housing 310 is connected to the first housing 121 and the second housing 221. The first heat sink 122 is located between the electronic control housing 310 and the first housing 121. The second heat sink 222 is located between the electronic control housing 310 and the second housing 221.

Refer to FIG. 12, FIG. 14, and FIG. 16 to FIG. 19. Further, an accommodating groove 400 is formed in a joint of the first housing 121 and the second housing 221. The accommodating groove 400 may be configured to at least accommodate electrical elements or devices such as a capacitor 375 of the motor controller 300. The capacitor 375 may be connected to a power device 371 corresponding to the first heat pipe 123 and connected to a power device 371 corresponding to the second heat pipe 223. This arrangement is conducive to integrating the motor controllers 300 of the two motors, enabling the two power devices 371 to share the capacitor 375, thereby improving an integration degree of the motor controller 300.

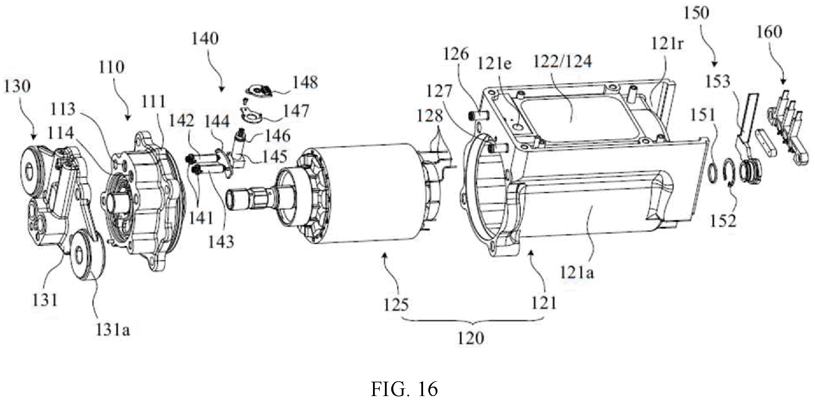

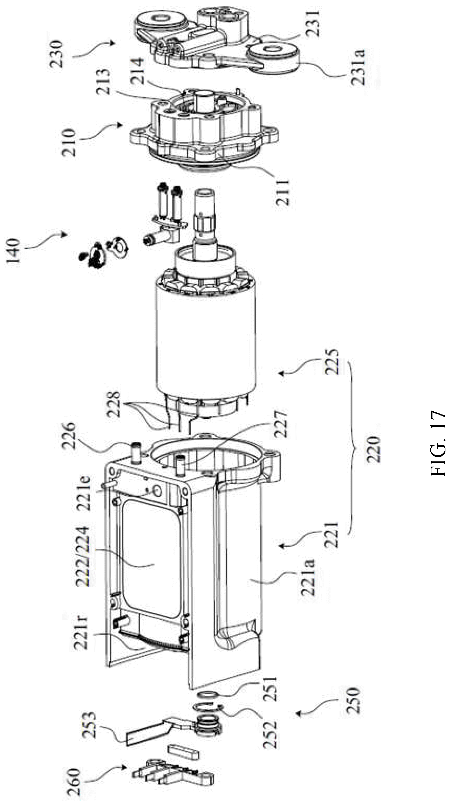

Refer to FIG. 12 to FIG. 19. Further, an end portion of the first housing body 121a of the first housing 121 facing the second housing 221 is recessed to form a first partial groove 121r (as shown in FIG. 12 and FIG. 16). An end portion of the second housing body 221a of the second housing 221 facing the first housing 121 is recessed to form a second partial groove 221r (as shown in FIG. 14 and FIG. 17). Upon assembly of the first housing 121 and the second housing 221, the first partial groove 121r and the second partial groove 221r form an accommodating groove 400. A position of the accommodating groove 400 herein relative to the first motor and the second motor, as well as functions implemented may be the same as that of the accommodating groove 500a below.

Refer to FIG. 11, FIG. 18, and FIG. 19. Optionally, the electronic control housing 310 may be fastened to the first housing 121 and the second housing 221 by using a fastener such as a bolt. It may be understood that, to facilitate locating and assembling of the electronic control housing 310 with the first housing 121 and the second housing 221, locating structures may be respectively disposed at corresponding positions between the electronic control housing 310 and the first housing 121, as well as between the electronic control housing 310 and the second housing 221. The locating structure herein may be divided into two portions. One portion of the locating structure is disposed in the electronic control housing 310, and the other portion of the locating structure is disposed in the first housing 121 and the second housing 221. One of the two portions of the locating structure may be configured to be a locating hole, and the other part may be configured to be a locating pin adapted to the locating hole.

Refer to FIG. 1 to FIG. 19. In an embodiment of the present disclosure, the first housing 121 may be welded to the second housing 221 in a friction welding manner to form a common housing. The common housing herein is an undetachable housing. During welding, the motor housing locating hole 121i on the first housing 121 and the motor housing locating pin 221i on the second housing 221 may be used to perform mutual limitation of the first housing 121 and the second housing 221. In this way, the recessed platform 121j of the first housing 121 may closely fit with the boss 221j of the second housing 221, so that a connection structure between the first housing 121 and the second housing 221 is firmer after friction welding.

For example, the recessed platform 121j (FIG. 2 and FIG. 6) is formed at an end portion of the first housing 121 in the second direction D2. The boss 221j (FIG. 4 and FIG. 7) is formed at an end portion of the second housing 221 in the second direction D2. The boss 221j is adapted to the recessed platform 121j. The boss 221j is welded and fixed to the recessed platform 121j. Cooperation between the recessed platform 121j and the boss 221j facilitates locating and assembling between the first housing 121 and the second housing 221. By connecting the first housing 121 and the second housing 221 in a welding manner, stability of the connection structure therebetween can be improved, and when an appropriate welding process is used, sealing performance of the joint between the first housing 121 and the second housing 221 can be better and more persistently maintained.

It may be understood that if the first housing 121 is connected to the second housing 221 in a welding manner, the welding manner may not be limited to friction welding. For example, another welding manner that can ensure stability of the connection structure between the first housing 121 and the second housing 221 and sealing performance of the joint may be selected.

Refer to FIG. 11 to FIG. 19. When the first housing 121 and the second housing 221 are separately manufactured and then assembled into an integrated dual-motor housing, the first flow channel 121o and the second flow channel 221o may be connected in parallel. That is, the first flow channel 121o and the second flow channel 221o are independent of each other in the first housing 121 and the second housing 221. In other words, the first flow channel 121o and the second flow channel 221o are respectively connected to respective apparatuses through pipelines outside the hydraulic energy supply device 600. For example, the first flow channel 121o and the second flow channel 221o are separately connected to a heat exchange circuit of an air conditioner to share the heat exchange medium with the air conditioner. A parallel connection manner of the first flow channel 121o and the second flow channel 221o may be applicable to an implementation in which the first housing 121 and the second housing 221 are first separately manufactured and then assembled together, and share the accommodating groove 400. The accommodating groove 400 herein will affect arrangement of the first flow channel 121o and the second flow channel 221o.

Specifically, as shown in FIG. 12 and FIG. 13, the first flow channel 121o is provided with a first opening 121p and a second opening 121q. The first opening 121p allows the heat exchange medium to flow into the first flow channel 121o, and the second opening 121q allows the heat exchange medium to flow out of the first flow channel 121o. Specifically, as shown in FIG. 14 and FIG. 15, the second flow channel 221o is provided with a third opening 221p and a fourth opening 221q. The third opening 221p allows the heat exchange medium to flow into the second flow channel 221o, and the fourth opening 221q allows the heat exchange medium to flow out of the second flow channel 221o. The first opening 121p and the second opening 121q are connected to the heat exchange circuit of the air conditioner through a set of pipelines. The third opening 221p and the fourth opening 221q are connected to the heat exchange circuit of the air conditioner through another set of pipelines.

Further, as shown in FIG. 12 and FIG. 13, an end portion of the first housing body 121a configured to mount the first hydraulic pump 110 is provided with a first opening 121p and a second opening 121q. The first opening 121p and the second opening 121q are spaced apart in a third direction D3 that is perpendicular to the first direction D1 and the second direction D2. The first housing 121 may further include a first liquid connector 126 and a second liquid connector 127. The first liquid connector 126 is mounted to the first opening 121p, and communicates with the first heat dissipation cavity 121t and the outside. The second liquid connector 127 is mounted to the second opening 121q, and communicates with the first heat dissipation cavity 121t and the outside. The first liquid connector 126 and the second liquid connector 127 are configured to connect to the pipelines. Accordingly, as shown in FIG. 14 and FIG. 15, an end portion of the second housing body 221a configured to mount the second hydraulic pump 210 is provided with a third opening 221p and a fourth opening 221q. The third opening 221p and the fourth opening 221q are spaced apart in the third direction D3 that is perpendicular to the first direction D1 and the second direction D2. The second housing 221 may further include a third liquid connector 226 and a fourth liquid connector 227. The third liquid connector 226 is mounted to the third opening 221p, and communicates with the second heat dissipation cavity 221t and the outside. The fourth liquid connector 227 is mounted to the fourth opening 221q, and communicates with the second heat dissipation cavity 221t and the outside. The third liquid connector 226 and the fourth liquid connector 227 are configured to connect to pipelines.

In other embodiments not shown, the first flow channel and the second flow channel are respectively located on two sides of the accommodating groove. The first flow channel and the second flow channel are connected in series. For example, an overflow trough is formed on side walls of the first housing and the second housing on a same side. The overflow trough separately communicate with the first flow channel and the second flow channel. Specifically, a first overflow trough may be formed on a side wall of the first housing close to the second housing. A second overflow trough is formed on a side wall of the second housing close to the first housing. The first overflow trough communicates with the second overflow trough to form the overflow trough by splicing. The hydraulic energy supply device 600 further includes an overflow cover plate. The overflow cover plate may be a portion of the first housing and the second housing. The overflow cover plate is detachably and hermetically connected to a notch of the overflow trough to form an overflow channel. The first flow channel and the second flow channel communicate with each other through the overflow channel.

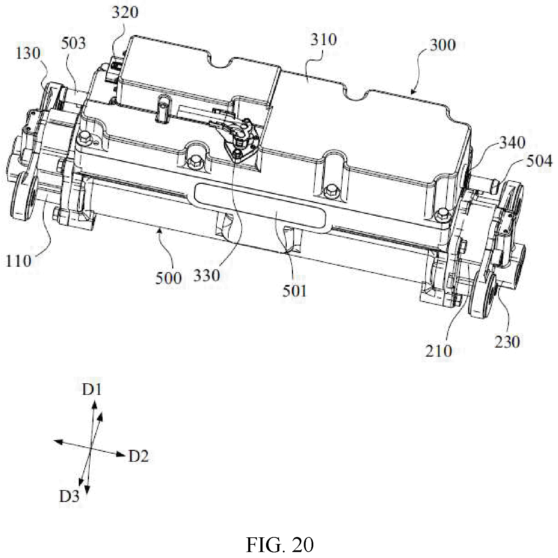

Refer to FIG. 20 to FIG. 25. In another embodiment of the present disclosure, the first housing and the second housing are made into an integrated dual-motor housing, which is shortened to an integrated housing 500, by using an integrally forming method. The integrated housing 500 is a common housing for the first motor 120 and the second motor 220. The common housing is an undetachable housing. Compared with the foregoing first motor pump 100 and the foregoing second motor pump 200, identical portions of the first motor pump and the second motor pump herein will not be repeated, the following description focuses primarily on differences.

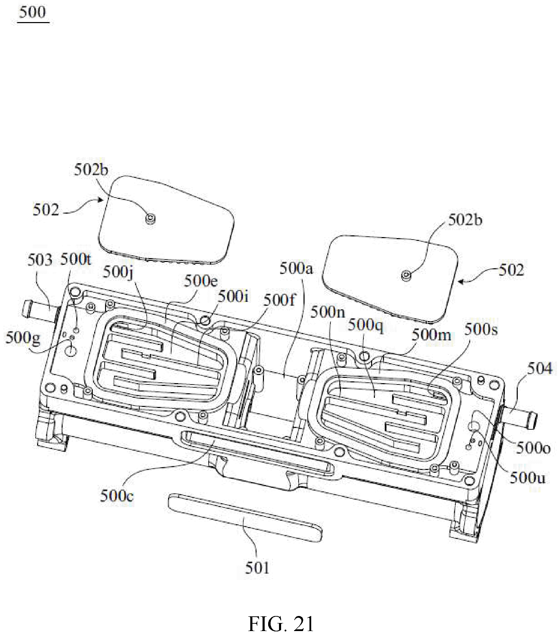

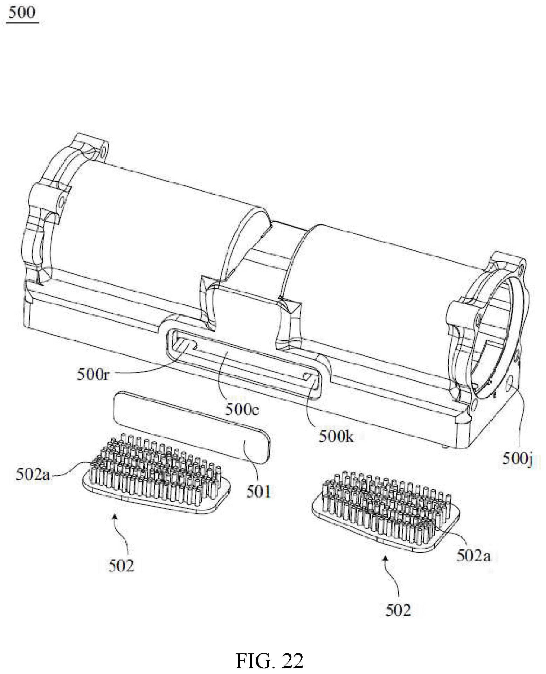

Refer to FIG. 21 and FIG. 22. For example, the integrated housing 500 is provided with a first liquid opening 500j, a second liquid opening 500k, a third liquid opening 500r, and a fourth liquid opening 500s. The first liquid opening 500j and the fourth liquid opening 500s are disposed at two ends of the integrated housing 500. The second liquid opening 500k and the third liquid opening 500r are located between the first liquid opening 500j and the fourth liquid opening 500s. The second liquid opening 500k and the first liquid opening 500j are spaced apart in the third direction D3 perpendicular to the first direction D1 and the second direction D2. Both the first liquid opening 500j and the second liquid opening 500k communicate with the first mounting groove 500e. A first flow guide rib 500f is disposed in the first mounting groove 500e. A flow channel board 502 is mounted in the first mounting groove 500e to form a first flow channel 500i. The fourth liquid opening 500s and the third liquid opening 500r are spaced apart in the third direction D3. Both the third liquid opening 500r and the fourth liquid opening 500s communicate with a second mounting groove 500m. A second flow guide rib 500n is disposed in the second mounting groove 500m. The flow channel board 502 is mounted in the second mounting groove 500m to form a second flow channel 500q. The second liquid opening 500k and the third liquid opening 500r are located at a same end of the integrated housing 500 in the third direction D3. An overflow groove 500c is formed in a surface of the integrated housing 500 facing outward in the third direction D3. The overflow groove 500c is disposed close to the second liquid opening 500k and the third liquid opening 500r in the third direction D3. The overflow groove 500c is located between the second liquid opening 500k and the third liquid opening 500r. The overflow groove 500c extends in the second direction D2 and separately communicate with the second liquid opening 500k and the third liquid opening 500r. A notch of the overflow groove 500c faces outward in the third direction D3. The integrated housing 500 may include an overflow cover plate 501. The overflow cover plate 501 covers the notch of the overflow groove 500c, to close the notch of the overflow groove 500c. An overflow channel is enclosed by the overflow cover plate 501, the first housing body 121a, and the second housing body 221a. Therefore, the first flow channel 500i and the second flow channel 500q formed on the integrated housing are connected in series with each other through the overflow channel.

Refer to FIG. 20 to FIG. 25. Further, the integrated housing 500 may further include a first liquid connector 503 and a second liquid connector 504. The first liquid connector 503 is mounted at the first liquid opening 500j, and communicates with the first mounting groove 500e and the outside. The second liquid connector 504 is mounted at the fourth liquid opening 500s, and communicates with the second mounting groove 500m and the outside. The first liquid connector 503 and the second liquid connector 504 may be connected to the heat exchange circuit of the air conditioner of the vehicle through pipelines, to share the heat exchange medium with the air conditioner.

Refer to FIG. 21, FIG. 23, and FIG. 25. Optionally, a locating boss 502b may be disposed on a surface of the flow channel board 502 facing the motor controller 300. The locating boss 502b is configured to abut against a drive circuit board 370, to locate the drive circuit board 370 and the flow channel board 502 in the first direction D1, so as to help preventing the drive circuit board 370 from moving relative to the flow channel board 502 in the first direction D1 due to vibration or other reasons, thereby preventing the power device 371 from being damaged by excessive stress.

In some other embodiments not shown, the overflow groove 500c may alternatively be disposed at other portions of the integrated housing 500. For example, the overflow groove 500c is arranged on a side of the integrated housing 500 facing the motor controller 300 in the first direction D1. In this case, a cover plate of the overflow groove 500c may be integrated with the flow channel board 502, or may be disposed separately.

Refer to FIG. 21, FIG. 23, and FIG. 25. In addition, the integrated housing 500 is further provided with a first via hole 500g and a third via hole 500o configured to mount detection assemblies 140.

Refer to FIG. 1 to FIG. 34. For example, the first motor 120 may include a first lead-out wire 128. The first lead-out wire 128 is electrically connected to or is a portion of a first winding in the first motor 120. For example, the first winding may include a first winding body and a first lead-out wire. The first lead-out wire includes a root end and a tip end. The root end and the tip end herein may be understood as two end portions of the first lead-out wire in a length direction thereof. The root end of the first lead-out wire is mounted at the stator core of the first motor 120. The first lead-out wire serves as the first lead-out wire 128. Or, the tip end of the first lead-out wire is connected to the first lead-out wire. The second motor 220 may include a second lead-out wire 228. The second lead-out wire 228 is electrically connected to or is a portion of a second winding in the second motor 220. For example, the second winding may include a second winding body and a second lead-out wire. The second lead-out wire includes a root end and a tip end. The root end and the tip end herein may be understood as two end portions of the second lead-out wire in a length direction thereof. The root end of the second lead-out wire is mounted at the stator core of the second motor 220. The second lead-out wire serves as the second lead-out wire 228. Or, the tip end of the second lead-out wire is connected to the second lead-out wire. The hydraulic energy supply device 600 may further include a first electrical connecting member 160 and a second electrical connecting member 260. Both the first electrical connecting member 160 and the second electrical connecting member 260 may be understood as copper busbars. The copper busbar is adapted to electrically connect to the motor controller 300. In other words, the first electrical connecting member 160 is connected to the first lead-out wire 128 and the motor controller 300. The second electrical connecting member 260 is connected to the second lead-out wire 228 and the motor controller 300. Electric energy from a power supply is converted by the motor controller 300 and then separately supplied to the first motor 120 and the second motor 220, to control operation statuses of the first motor 120 and the second motor 220.

It may be understood that the first electrical connecting member 160 may be plugged into an electrical connecting portion between the motor controller 300. The first electrical connecting member 160 may be connected to the first lead-out wire 128 by means of plugging, welding, and using a fastener.

Refer to FIG. 2 to FIG. 10 and FIG. 12 to FIG. 19. Further, an accommodating groove 400 is formed between the first motor 120 and the second motor 220. The first lead-out wire 128, the second lead-out wire 228, the first electrical connecting member 160, and the second electrical connecting member 260 are at least partially located in the accommodating groove 400. Electrical elements or devices such as a capacitor 375 of the motor controller 300 may also be accommodated in the accommodating groove. With arrangement of the accommodating groove between the first motor 120 and the second motor 220 to accommodate the electrical elements or devices of the motor controller 300, such as a portion of the first lead-out wire 128, a portion of the second lead-out wire 228,the first electrical connecting member 160, the second electrical connecting member 260, and the capacitor 375, space utilization of the first motor 120 and the second motor 220 in the axial direction D2 can be improved. This arrangement is further conducive to improving an integration degree of the motor controller, and improves compactness of the structure in the first direction D1 while reducing space occupation in the first direction D1.

Refer to FIG. 6, FIG. 7, FIG. 16, and FIG. 17. For example, both the first motor 120 and the second motor 220 may be three-phase motors. Accordingly, the first motor 120 and the second motor 220 each have a three-phase winding. The first lead-out wire 128 includes a three-phase first lead-out wire 128. The second lead-out wire 228 includes a three-phase second lead-out wire 228. The first electrical connecting member 160 includes a three-phase input portion and a three-phase output portion. The three-phase input portion is connected to the motor controller 300. The three-phase output portion is connected to the three-phase winding of the first motor 120. A structure of the second electrical connecting member 260 may be the same as that of the first electrical connecting member 160.

Refer to FIG. 6, FIG. 7, FIG. 16, and FIG. 17. Further, the first motor 120 includes a three-phase first winding and a three-phase first lead-out wire 128. The first electrical connecting member 160 includes a three-phase first electrical connecting end 161, and each phase of first lead-out wires 128 is connected to a respective phase of the first winding and a respective phase of the first electrical connecting end 161 in a one-to-one correspondence. Accordingly, the second motor 220 includes a three-phase second winding and a three-phase second lead-out wire 228. The second electrical connecting member 260 includes a three-phase second electrical terminal, and each phase of second lead-out wires 228 is connected to a respective phase of the second winding and a respective phase of the second electrical terminal in a one-to-one correspondence.

Further, refer to FIG. 6, FIG. 8, FIG. 10, FIG. 16, FIG. 18, and FIG. 19. The first electrical connecting member 160 may be configured to be a first copper busbar. The first electrical connecting end 161 and the second electrical connecting end 169 may be configured to be structures made of copper. The first electrical connecting end 161 and the second electrical connecting end 169 that are in a same phase or electrically connected to a same winding may be configured to be a single piece. The second electrical connecting end 169 may be electrically connected to the motor controller 300 by means of plugging. Accordingly, refer to FIG. 7, FIG. 8, FIG. 10, FIG. 17, FIG. 18, and FIG. 19. The second electrical connecting member 260 may be configured to be a second copper busbar. The second electrical terminal and the fifth electrical terminal may be configured to be structures made of copper. The second electrical terminal and the fifth electrical terminal that are in a same phase or electrically connected to a same winding may be configured to be a single piece. The fifth electrical terminal may be electrically connected to the motor controller 300 by means of plugging.

The foregoing first motor 120 may include a first winding (not shown). The first winding is at least in indirect abutting connection, plug-in connection, or snap fit with the first electrical connecting member. It may be understood that when the first lead-out wire 128 belongs to a portion of the first lead-out wire of the first winding, the first winding is in direct abutting connection, plug-in connection, or snap fit with the first electrical connecting member 160. When the first lead-out wire 128 does not belong to the first winding but is connected to the first lead-out wire of the first winding, the first winding is in indirect abutting connection, plug-in connection, or snap fit with the first electrical connecting member 160 through the first lead-out wire 128. The second electrical connecting member 260 is connected to the second motor 220 in a same manner.

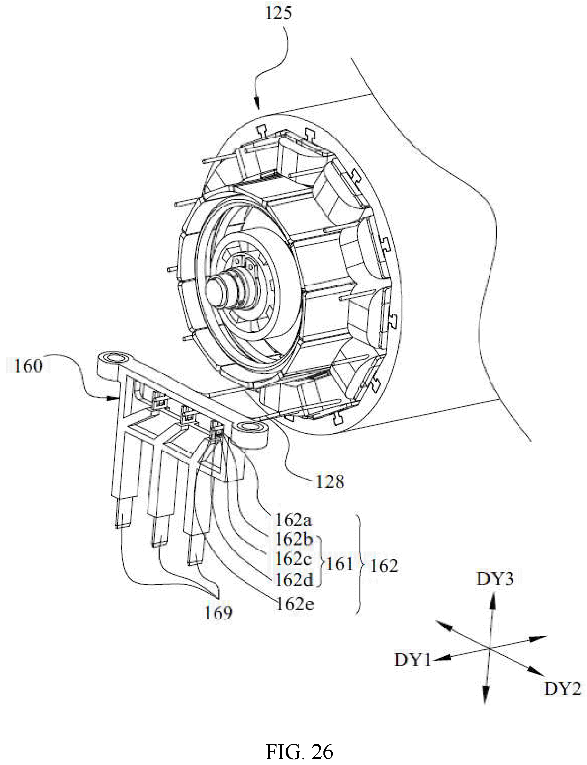

The first electrical connecting member 160 or the second electrical connecting member 260 of the present disclosure will be described in detail below with reference to examples shown in FIG. 26 to FIG. 34.

FIG. 26 to FIG. 28 show an example of the first electrical connecting member 160. The first electrical connecting member 160 and the second electrical connecting member 260 have a same structure. Now, the first electrical connecting member 160 is described. The first electrical connecting end 161 of the first electrical connecting member 160 has a bump. After the first motor body 125 is assembled, an inner conductor of the first lead-out wire 128 is pressed against and electrically connected to the bump. Because two sides of the bump are circular arcs, the first lead-out wire 128 can be guided through the circular arc surfaces when the first lead-out wire 128 is assembled, thereby facilitating abutting against a more protruding portion of the bump . When the inner conductor of the first lead-out wire 128 abuts against the more protruding portion of the bump, an abutting force between the first electrical connecting end 161 and the first lead-out wire 128 is greater, so that the first electrical connecting end 161 and the first lead-out wire 128 can be more reliably conductively connected. Because the inner conductor of the first lead-out wire 128 is in contact with the circular arc surfaces of the bump, resulting in a small contact area, such a first electrical connection is suitable for a motor with a low rated current.

Refer to FIG. 26 to FIG. 28 again. The first electrical connecting end 161 according to an embodiment of the present disclosure is configured with a protrusion 162. The protrusion 162 herein may be referred to as a bump. One end of the first lead-out wire 128 is electrically connected to or is a portion of a first winding of the first motor 120. The other end of the first lead-out wire 128 extends in a first extension direction DY1 and abuts against and is electrically connected to the protrusion 162 in a second extension direction DY2. The first extension direction DY1 herein may be parallel or substantially parallel to the first direction D1. It may be understood that the first extension direction DY1 is substantially parallel to the first direction D1 that an included angle between the first extension direction DY1 and the first direction D1 is within a range of 0° to 15°. The second extension direction DY2 intersects with the first extension direction DY1.

Refer to FIG. 26 to FIG. 28. For example, the first electrical connecting member 160 may include a first electrical connecting end 161. The first electrical connecting member 160 is adapted to electrical connect to the motor controller 300. One end of the first winding abuts against or is welded to the first electrical connecting end 161. The first winding abuts against or is welded to the first electrical connecting end 161 of the electrical connecting member. This arrangement can simplify an electrical connection structure between the first winding and the first electrical connecting member 160, thereby reducing processing costs and improving assembly efficiency.

Continue to refer to FIG. 26 to FIG. 28. For example, the first motor 120 may include a first stator core. The first winding may include a first winding body (not shown) and a first lead-out wire 128. The first winding body is fixedly connected to the first stator core. A first end of the first lead-out wire 128 is connected to the first winding body. A second end of the first lead-out wire 128 abuts against the first electrical connecting end 161. The first winding body and the first lead-out wire 128 may be an integrated component, or the first winding body and the first lead-out wire 128 may be two different wires. A connection between the first winding body and the first electrical connecting end 161 is implemented by abutting the first lead-out wire 128 of the first winding body against the first electrical connecting end 161. This connection manner is simpler and easier to operate.

Continue to refer to FIG. 26 to FIG. 28. Further, the first electrical connecting end 161 may include a protrusion 162. A side surface of the first lead-out wire 128 abuts against the protrusion 162. The first lead-out wire 128 is inclined to the axial direction D2 of the first motor 120. If the first end of the first lead-out wire 128 is fixed relative to the stator or the first housing 121, and the first lead-out wire in an initial state, in which the first lead-out wire is not connected to the protrusion 162, is parallel or substantially parallel to the axial direction D2 of the first motor 120, the first lead-out wire 128 abuts against the protrusion 162 by applying a force to the second end of the first lead-out wire 128, and finally the first lead-out wire 128 is inclined to the axial direction D2 of the first motor 120. In this case, the first lead-out wire 128 abuts against the protrusion 162 by virtue of an elastic force after elastic deformation, so that a connection between the first lead-out wire 128 and the protrusion 162 is more reliable.

Continue to refer to FIG. 26 to FIG. 28. Optionally, the first winding body and the first lead-out wire 128 are two different wires. Hardness of the first lead-out wire 128 is greater than that of the first winding body. The first end of the first lead-out wire 128 is at least indirectly fixed to the first stator core. The first electrical connecting end 161 includes a protrusion. The first lead-out wire 128 abuts against the protrusion 162. In a plane perpendicular to the axial direction D2 of the first motor 120, a projection of the protrusion 162 partially overlaps a projection of the first lead-out wire 128. Herein, the first lead-out wire 128 is elastically deformed and abuts against the protrusion 162, to implement a reliable connection between the first lead-out wire 128 and the protrusion 162, which is more convenient and reliable.

It may be understood that the first lead-out wire 128 in a natural state may not be a wire extending straightly, for example, a wire extending along a curve. When one end of the curved wire is fixed, the other end of the curved wire under force can be deformed to abut against the protrusion and thereby achieving a purpose of reliably abutting, which also falls within the scope of the present disclosure.

In other embodiments, when the first lead-out wire overlaps the protrusion 162, there may be no mutual interaction force between the first lead-out wire and the protrusion 162. In this case, the first lead-out wire may reliably abut against or be connected to the protrusion by means of another structure or processes such as welding.

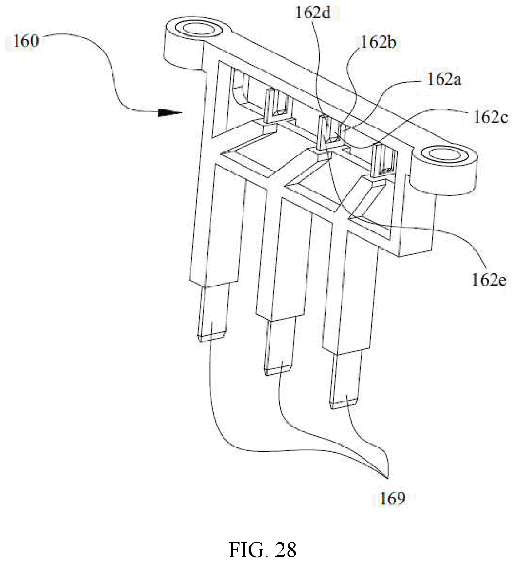

In examples shown in FIG. 26 and FIG. 28, the protrusions are circular arc-shaped. The first lead-out wire 128 abuts against an apex of the protrusion. In this way, a contact area between the first lead-out wire 128 and the protrusion is relatively small, which is suitable for an application scenario that carries a small current.

For example, the first electrical connecting end 161 may include a plate body (not labeled). The protrusion is formed by a portion of the plate body protruding toward one side (as shown in FIG. 26 to FIG. 28), or the protrusion is disposed on one side surface of the plate body. Herein, a manufacturing manner may be flexibly selected according to an actual requirement, to implement processing and manufacturing of the protrusion portion.

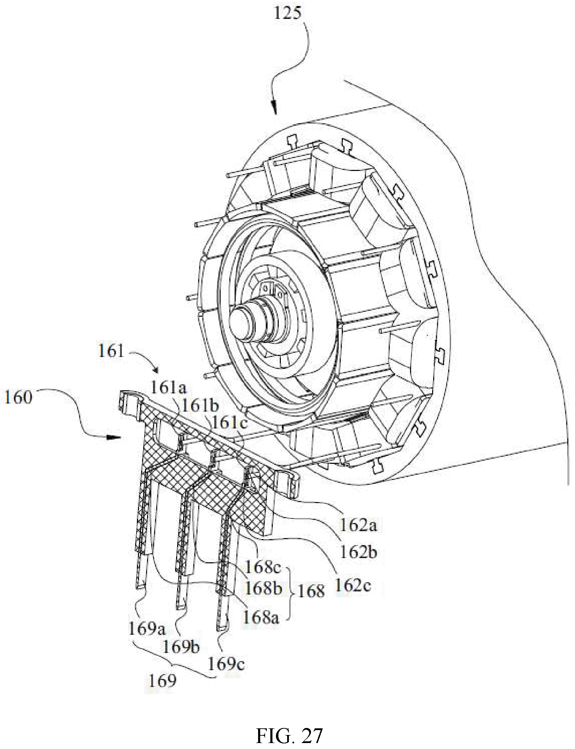

Refer to FIG. 26 and FIG. 27. Optionally, the first motor 120 includes a three-phase first lead-out wire 128. The first electrical connecting member 160 includes a three-phase first electrical connecting end 161. Each phase of first lead-out wires 128 is connected to a respective phase of the first electrical connecting end 161 in a one-to-one correspondence. The first electrical connecting member 160 is configured to be a copper busbar.

Refer to FIG. 26 to FIG. 28. In addition, the first electrical connecting member 160 may include a second electrical connecting end 169. The second electrical connecting end 169 is adapted to connect to the motor controller 300. Optionally, a connecting plate 168 is further disposed between the second electrical connecting end 169 and the first electrical connecting end 161. An included angle between the connecting plate and the second electrical connecting end 169 is greater than 90° and less than 180°. In this way, a distance between the second electrical connecting end and the first electrical connecting end may be increased.

Continue to refer to FIG. 26 to FIG. 28. For example, three sequentially disposed connecting plates 168 are respectively denoted as a first connecting plate 168a, a second connecting plate 168b, and a third connecting plate 168c. The first electrical connecting ends 161 to which the first connecting plate 168a, the second connecting plate 168b, and the third connecting plate 168c are connected are respectively denoted as a first electrical terminal 161a, a second electrical terminal 161b, and a third electrical terminal 161c. The second electrical connecting ends to which the first connecting plate 168a, the second connecting plate 168b, and the third connecting plate 168c are connected are respectively denoted as a fourth electrical terminal 169a, a fifth electrical terminal 169b, and a sixth electrical terminal 169c. The first connecting plate 168a is inclined in a direction away from the first electrical terminal 161a and the second electrical terminal 161b. An inclination direction of the second connecting plate 168b and the third connecting plate 168c is the same as the inclination direction of the first connecting plate 168a. An included angle between the first connecting plate 168a and the fourth electrical terminal 169a is α1. An included angle between the second connecting plate 168b and the fifth electrical terminal 169b is α2. An included angle between the third connecting plate 168c and the sixth electrical terminal 169c is α3. α1 < α2 < α3. This arrangement can ensure safe distances between the three second electrical connecting ends 169, and reduce distances between the three first electrical connecting ends 161, thereby facilitating arrangement of the three-phase first lead-out wire 128.

Optional, the first winding may include a first winding body and a first lead-out wire 128. A first end of the first lead-out wire 128 is connected to the first winding body. The first electrical connecting member includes a first electrical connecting end. The first electrical connecting end includes a protrusion. The first lead-out wire 128 is welded to the protrusion 162. With arrangement of the protrusion 162, welding is performed after locating of the first lead-out wire 128 and the first electrical connecting end 161 is implemented. This arrangement not only ensures reliability of a connection between the lead-out wire and the first electrical connecting end 161, but also facilitates implementation of a welding process.

Refer to FIG. 26 and FIG. 27. Further, the first electrical connecting end 161 is disposed to extend in a third extension direction DY3. The third extension direction DY3 intersects with the first extension direction DY1 and the second extension direction DY2.

Refer to FIG. 26 to FIG. 28. For example, in a plane perpendicular to the third extension direction DY3 and intersecting with the protrusion 162, the first electrical connecting end 161 may include a first vacant portion 162a, a first guide portion 162b, and an abutting portion 162c that are sequentially connected in the first extension direction DY1. The first vacant portion 162a is spaced apart from the abutting portion 162c in the first extension direction DY1. The first vacant portion 162a is closer to the first winding than the abutting portion 162c in the first extension direction DY1. The first vacant portion 162a is spaced apart from the abutting portion 162c in the second extension direction DY2. The protrusion 162 includes a first guide portion 162b and an abutting portion 162c. When the first electrical connecting member 160 moves in the first extension direction DY1 to a certain position where the first electrical connecting member 160 is disengaged from the first lead-out wire 128, in a plane perpendicular to the first extension direction DY1, an end portion of the first lead-out wire 128 away from the winding of the first motor 120 is located between the first vacant portion 162a and the abutting portion 162c in the second extension direction DY2. Furthermore, an end portion of the first lead-out wire 128 away from the winding of the first motor 120 is separately spaced apart from the first vacant portion 162a and the abutting portion 162c in the second extension direction DY2. When the first electrical connecting member 160 approaches the first lead-out wire 128 in the first extension direction DY1 or the first lead-out wire 128 approaches the first electrical connecting member 160 in the first extension direction DY1, the end portion of the first lead-out wire 128 is staggered from the first vacant portion 162a in the second extension direction DY2, so that the end portion of the first lead-out wire 128 first abuts against the first guide portion 162b, and then, under guiding effect of the first guide portion 162b, the end portion of the first lead-out wire 128 gradually moves toward the abutting portion 162c, until the end portion of the first lead-out wire 128 moves to a position where the end portion completely abuts against the abutting portion 162c. While the end portion of the first lead-out wire 128 moves from the first guide portion 162b to the abutting portion 162c, an extrusion force between the first electrical connecting end 161 and the first lead-out wire 128 in the second extension direction DY2 gradually increases, thereby ensuring that the first lead-out wire 128 can reliably abut against the abutting portion 162c, and preventing poor electrical contact.

It may be understood that a cross-sectional shape of the first guide portion 162b herein may be a straight line, may be a curve, or may be a combination of a straight line and a curve. In addition, a joint between the first guide portion 162b and the first vacant portion 162a and a joint between the first guide portion 162b and the abutting portion 162c may be in a smooth transition form, to ensure that the end portion of the first lead-out wire 128 can smoothly slide from the first guide portion 162b to the abutting portion 162c.

Refer to FIG. 26 to FIG. 28. Further, in a plane perpendicular to the third extension direction DY3 and intersecting with the protrusion 162, the first electrical connecting end 161 may further include a second guide portion 162d and a second vacant portion 162e that are sequentially connected in the first extension direction DY1. The second guide portion 162d and the second vacant portion 162e are located on a side of the abutting portion 162c away from the first guide portion 162b in the first extension direction DY1. The second guide portion 162d is connected to the abutting portion 162c. The second vacant portion 162e and the first vacant portion 162a are located on a same side of the abutting portion 162c in the second extension direction DY2. The second vacant portion 162e is spaced from the abutting portion 162c in the second extension direction DY2. The protrusion 162 further includes a second guide portion 162d. Therefore, in an example where the first electrical connecting end 161 is provided with the second guide portion 162d and the second vacant portion 162e, a cross-sectional shape of the first electrical connecting end 161 approximates a "Ω" shape or an "inverted U" shape. The "Ω" shape or the "inverted U" shape herein is merely a shape that is relatively similar to the cross-sectional shape of the first electrical connecting end 161 in terms of an overall contour, and is not a limitation on the cross-sectional shape of the first electrical connecting end 161. Additional arrangement of the second guide portion 162d and the second vacant portion 162e can provide two more bending structures for the first electrical connecting end 161, which is conducive to improving structural strength of the first electrical connecting end 161. Therefore, the first electrical connecting end 161 is less susceptible to deformation or structural failure when abutting against the first lead-out wire 128 in the second extension direction DY2.

It may be understood that a cross-sectional shape of the second guide portion 162d herein may be a straight line, may be a curve, or may be a combination of a straight line and a curve. Further, a joint between the second guide portion 162d and the second vacant portion 162e and a joint between the second guide portion 162d and the abutting portion 162c may be in a smooth transition form. The second guide portion 162d and the second vacant portion 162e may not be in contact with the lead-out wire, and the second guide portion 162d may not guide movement of the first lead-out wire 128 during assembly. Certainly, in some cases, if lead-out wires may be assembled to both opposite ends of the first electrical connecting end 161 in the first extension direction DY1, for example, when lead-out wires of the two motors share one electrical connection terminal, a function of the second guide portion 162d is the same as that of the first guide portion 162b, and a function of the second vacant portion 162e is the same as that of the first vacant portion 162a.

In some other embodiments, the second guide portion 162d and the second vacant portion 162e may not be provided. Optionally, the abutting portion 162c is configured to extend in the first extension direction DY1, in a direction away from the first vacant portion 162a. This is conducive to increasing a conductive contact area between the abutting portion 162c and the first lead-out wire 128.

Optionally, the first lead-out wire 128 is spaced apart from the first vacant portion 162a in the second extension direction DY2. When the first lead-out wire 128 is connected to the first electrical connecting end 161, the first lead-out wire 128 is spaced from the first vacant portion 162a, to ensure a greater abutting force between the first lead-out wire 128 and the abutting portion 162c in the second direction D2.

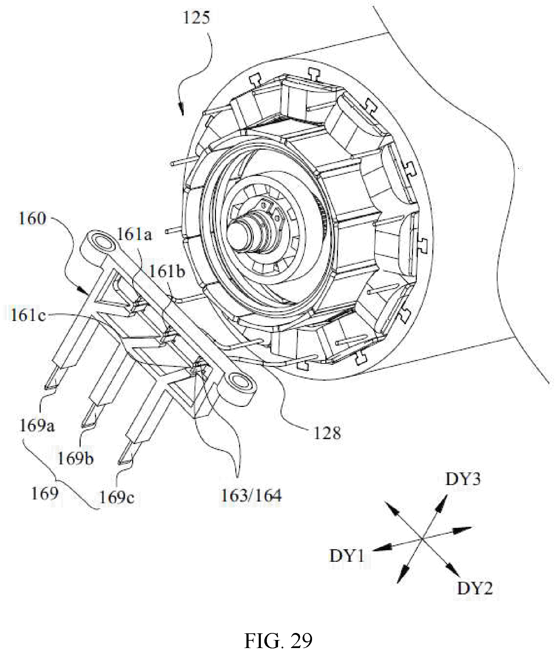

FIG. 29 to FIG. 32 show another example of the first electrical connecting member 160 or the second electrical connecting member 260. The first electrical connecting member 160 and the second electrical connecting member 260 have a same structure. Now, the first electrical connecting member 160 is described. A first electrical connecting end 161 of the first electrical connecting member 160 includes a circular arc structure configured to assemble with the conical barrel 163. A center of the circular arc structure may be collinear with an end portion of the inner conductor of the first lead-out wire 128. To facilitate assembly of the first lead-out wire 128 with the conical barrel 163, one end of the conical barrel 163 facing the first motor 120 is configured to be a guide opening. The guide opening is horn-shaped, that is, an inner diameter of the guide opening gradually decreases in a direction away from the first motor 120. A maximum inner diameter of the guide opening is larger than an outer diameter of the conductor of the first lead-out wire 128. To ensure good contact between the first lead-out wire 128 and the conical barrel 163 after assembly, an inner diameter of an end of the conical barrel 163 away from the guide opening is smaller than the outer diameter of the conductor of the first lead-out wire 128. In addition, an opening structure is disposed at an end of the conical barrel 163 away from the guide opening. When the first lead-out wire 128 is assembled to the end of the conical barrel 163 having a smaller inner diameter, the opening structure expands due to a radial extrusion force. This facilitates passage of the first lead-out wire 128 through the conical barrel 163, increases a contact area between the first lead-out wire 128 and the conical barrel 163, and further increases stability of a connection structure between the conical barrel 163 and the first lead-out wire 128. That is, after being mounted into the conical barrel 163, the first lead-out wire 128 is encircled by a circumference of the conical barrel 163, to achieve a good position limitation and provide a large contact area, which is suitable for use in a motor that needs to carry a relatively large current.

Refer to FIG. 29 to FIG. 32. The first electrical connecting end 161 according to the present disclosure may include a connecting hole 163a extending in the first extension direction DY1, and the connecting hole 163a has a first end 163b and a second end 163c facing opposite directions in the first extension direction DY1. The first end 163b is closer to a first cavity, that is, closer to the first winding, than the second end 163c in the first extension direction DY1. An aperture of the second end 163c is smaller than or equal to the outer diameter of the conductor of the first lead-out wire 128. This ensures that the conductor of the first lead-out wire 128 can be in electrical contact with the first electrical connecting end 161 when passing through the connecting hole 163a. The aperture of the first end 163b is greater than the outer diameter of the conductor of the first lead-out wire 128. This can facilitate the conductor of the first lead-out wire 128 to enter the connecting hole 163a from the first end 163b. The first end 163b can guide insertion of the conductor of the first lead-out wire 128, and may also be referred to as a guide opening. The conductor of the first lead-out wire 128 passes through the connecting hole 163a and is electrically connected to the first electrical connecting end 161.

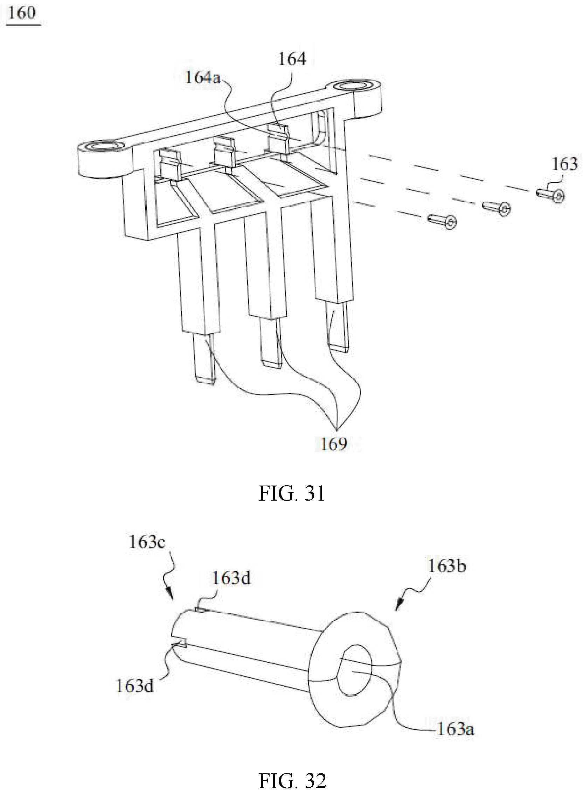

Refer to FIG. 32. For example, the aperture of the second end 163c is smaller than the outer diameter of the conductor of the first lead-out wire 128. The first electrical connecting end 161 may include a connecting barrel extending in the first extension direction DY1. The connecting hole 163a passes through the connecting barrel in the first extension direction DY1. A portion of the connecting barrel corresponding to the second end 163c is provided with a groove 163d. The groove 163d may also be referred to as an open structure, or a fracture opening, or a fracture mark. The groove 163d extends to an end portion of the second end 163c of the connecting barrel in an axial direction of the connecting barrel or in a depth direction of the connecting hole 163a. The groove 163d communicates with the connecting hole 163a and the outside in a radial direction. The groove 163d extends in the first extension direction DY1 to an end portion of the connecting barrel away from the first end 163b. The groove 163d is configured to adaptively expand when the conductor of the first lead-out wire 128 passes through the second end 163c and is subjected to an extrusion force in the radial direction of the connecting barrel. It may be understood that when the groove 163d expands under force, a portion of a connecting barrel between adjacent grooves 163d expands outward and deforms in a radial direction, and applies an extrusion pre-tightening force to the conductor of the first lead-out wire 128.

Refer to FIG. 32. Further, the connecting barrel is provided with at least two grooves 163d. The grooves 163d are spaced apart in a circumferential direction of the connecting barrel. Arrangement of the plurality of grooves 163d is conducive to improving uniformity of force distribution between the connecting barrel and the first lead-out wire 128.

Refer to FIG. 29 and FIG. 32. Optionally, the foregoing at least two grooves 163d are equally spaced apart in the circumferential direction of the connecting barrel.

In an example shown in FIG. 32, the connecting barrel is provided with three grooves 163d.

Optionally, the connecting barrel may be configured to be a metal barrel capable of deforming elastically. This can increase a radial force between the connecting barrel and the first lead-out wire 128, thereby ensuring a more reliable connection therebetween, and being conducive to preventing electrical failure and prolonging a service life.

Preferably, the first electrical connecting end 161 is configured to be a structure made of copper.

Refer to FIG. 29 to FIG. 32. In addition, the first electrical connecting member 160 may further include a base portion 164. The base portion 164 is provided with a connecting groove 164a. The connecting groove 164a is adapted to accommodate a portion of the connecting barrel. The connecting barrel is fixedly connected to the base portion 164. The base portion 164 plays a role in supporting and fixing the connecting barrel. The connecting barrel and the base portion 164 may be separately manufactured and then assembled together. With arrangement of the connecting groove 164a on the base portion 164, locating of a connecting position of the connecting barrel on the base portion 164 is facilitated.

For example, a shape of the connecting groove 164a may be adapted to an outer shape of the connecting barrel.

Optionally, both the base portion 164 and the connecting barrel may be made of copper.

Optionally, the connecting barrel may be fixed to the base portion 164 by means of welding.

Refer to FIG. 29 to FIG. 32, in conjunction with FIG. 27. In addition, the first electrical connecting member 160 may include a second electrical connecting end 169. The second electrical connecting end 169 is adapted to connect to the motor controller 300. Optionally, a connecting plate 168 is further disposed between the second electrical connecting end 169 and the first electrical connecting end 161. An included angle between the connecting plate and the second electrical connecting end 169 is greater than 90° and less than 180°. In this way, a distance between the second electrical connecting end and the first electrical connecting end may be increased.

Continue to refer to FIG. 29 to FIG. 32, in conjunction with FIG. 27. For example, three sequentially disposed connecting plates 168 are respectively denoted as a first connecting plate 168a, a second connecting plate 168b, and a third connecting plate 168c. The first electrical connecting ends 161 to which the first connecting plate 168a, the second connecting plate 168b, and the third connecting plate 168c are connected are respectively denoted as a first electrical terminal 161a, a second electrical terminal 161b, and a third electrical terminal 161c. The second electrical connecting ends to which the first connecting plate 168a, the second connecting plate 168b, and the third connecting plate 168c are connected are respectively denoted as a fourth electrical terminal 169a, a fifth electrical terminal 169b, and a sixth electrical terminal 169c. The first connecting plate 168a is inclined in a direction away from the first electrical terminal 161a and the second electrical terminal 161b. An inclination direction of the second connecting plate 168b and the third connecting plate 168c is the same as the inclination direction of the first connecting plate 168a. An included angle between the first connecting plate 168a and the fourth electrical terminal 169a is α1. An included angle between the second connecting plate 168b and the fifth electrical terminal 169b is α2. An included angle between the third connecting plate 168c and the sixth electrical terminal 169c is α3. α1 < α2 < α3. This arrangement can ensure safe distances between the three second electrical connecting ends 169, and reduce distances between the three first electrical connecting ends 161, thereby facilitating arrangement of the three-phase first lead-out wire 128.

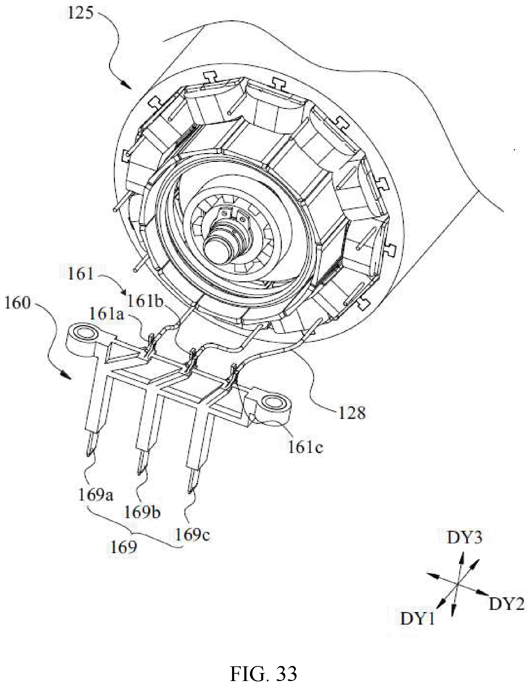

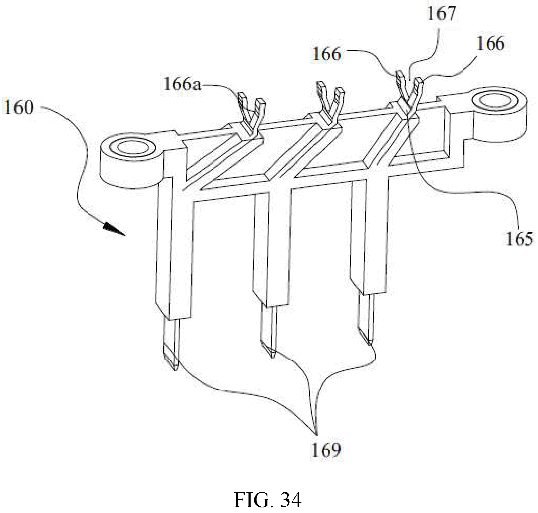

FIG. 33 and FIG. 34 show yet another example of the first electrical connecting member 160 or the second electrical connecting member 260. The first electrical connecting member 160 and the second electrical connecting member 260 have a same structure. Now, the first electrical connecting member 160 is described. The first electrical connecting end 161 of the first electrical connecting member 160 is divided into two small copper busbars, and a shape of a combination of the two small copper busbars is a structure similar to a "Y" shape. A clamping opening is formed at an end portion of the first electrical connecting end 161, thereby facilitating assembly with the first lead-out wire 128. In addition, the two small copper busbars have circular arc structures, and centers of the circular arc structures may be arranged concentrically with an end portion of the first lead-out wire 128. In this way, when being assembled to the circular arc structure, the first lead-out wire 128 can bring into good contact with the copper busbar. Further, a diameter of the circular arc structure is slightly smaller than the outer diameter of the conductor of the first lead-out wire 128, so that contact between the two is firmer. A contact form between the circular arc structure and the conductor of the first lead-out wire 128 may be contact of the circular arc surfaces. This increases a contact area and facilitates transmission of a larger current. Furthermore, a semi-circular arc surface has certain limiting effect on a three-phase wire of the motor.

Refer to FIG. 33 and FIG. 34. The first electrical connecting end 161 according to this embodiment may include a base portion 165 and at least two clamping portions 166 sequentially arranged in the first extension direction DY1. Each clamping portion 166 is connected to the base portion 165. In a plane perpendicular to the first extension direction DY1, ends that are of the clamping portions 166 and that are away from the base portion 165 are spaced apart in the second extension direction DY2 to form a clamping opening 167. One end of the first lead-out wire 128 is electrically connected to the first winding of the first motor 120. The other end of the first lead-out wire 128 extends in the first direction D1 and is clamped into the clamping opening 167. Furthermore, the first lead-out wire 128 is electrically connected to the clamping portion 166. That is, the first electrical connecting end 161 is electrically connected to the conductor of the first lead-out wire 128. The second extension direction DY2 intersects with the first extension direction DY1. The first extension direction DY1 herein may be parallel or substantially parallel to the first direction D1. It may be understood that the first extension direction DY1 is substantially parallel to the first direction D1 that an included angle between the first extension direction DY1 and the first direction D1 is within a range of 0° to 15°.

During mounting, the first lead-out wire 128 may be first inserted into the clamping opening 167 in the first extension direction DY1, or the first lead-out wire 128 may be put into the clamping opening 167 in the third direction D3, or the end portion of the first lead-out wire 128 is placed into the clamping opening 167 along other directions or other moving tracks. Then, if the clamping opening 167 is insufficient to tightly clamp the first lead-out wire 128, the clamping portion 166 may be bent manually or by an automated machine to more closely fit with the first lead-out wire 128. If the clamping opening 167 can achieve a close fit with the first lead-out wire 128, the first lead-out wire 128 may also be directly clamped by the clamping opening 167.

For example, in a plane perpendicular to the first extension direction DY1, ends that are of the clamping portions 166 and that are close to the base portion 165 coincides. It may be understood that an extension direction of a portion of the clamping portions 166 among the clamping portions 166 are arranged to intersect with an extension direction of another portion of the clamping portions 166. In a plane perpendicular to the first extension direction DY1, a contour shape of each clamping portion 166 and the base portion 165 approximates a "Y" shape.

Further, the first electrical connecting end 161 is disposed to extend in the third extension direction DY3. The base portion 165 is located at an end portion of the first electrical connecting end 161 in the third extension direction DY3. The third extension direction DY3 intersects with the first extension direction DY1 and the second extension direction DY2.

In an illustrated example, the first electrical connecting end 161 may include two clamping portions 166. Extension directions of the two clamping portions 166 intersect with each other. The two clamping portions 166 are simple in structure and convenient to manufacture, and can save space and reduce costs.

Specifically, the first electrical connecting end 161 is made of a metal sheet. A manufacturing process may be as follows: One end of a metal sheet is divided into two partial metal sheets that are arranged side by side in a width direction, and a slit for separating extends in a length direction of the metal sheet and only penetrates through one end of the metal sheet. Then, the two separated partial metal sheets are bent in opposite directions in a thickness direction of the metal sheet, to form the first electrical connecting end 161. The metal sheet herein is preferably a copper sheet.

It may be understood that in another example not shown in the present disclosure, the first electrical connecting end 161 may include three or more clamping portions 166.

For example, a surface of the clamping portion 166 facing the clamping opening 167 is recessed to form a locating groove 166a. The locating groove 166a is configured to accommodate a portion of the conductor of the first lead-out wire 128 to restrict the first lead-out wire 128 from exiting the clamping opening 167.

In an example shown in FIG. 34, the locating groove 166a is configured to be a circular arc-shaped groove. This facilitates fitting and bonding with the conductor of the first lead-out wire 128, thereby increasing a contact area.

Further, the first electrical connecting end 161 may include two clamping portions 166. A gap between the locating grooves 166a of the two clamping portions 166 in the second extension direction DY2 is less than or equal to the outer diameter of the conductor of the first lead-out wire 128. Therefore, when the conductor of the first lead-out wire 128 is placed into the clamping opening 167, the conductor of the first lead-out wire 128 can be brought into contact with an inner surface of the locating groove 166a. Particularly, when the gap between the locating grooves 166a of the two clamping portions 166 in the second extension direction DY2 is smaller than the outer diameter of the conductor of the first lead-out wire 128, the two clamping portions 166 can also apply a clamping force to the conductor of the first lead-out wire 128. Therefore, an electrical connection between the first electrical connecting end 161 and the conductor of the first lead-out wire 128 is more reliable and stable.

Refer to FIG. 33 and FIG. 34, in conjunction with FIG. 27. In addition, the first electrical connecting member 160 may include a second electrical connecting end 169. The second electrical connecting end 169 is adapted to connect to the motor controller 300. Optionally, a connecting plate 168 is further disposed between the second electrical connecting end 169 and the first electrical connecting end 161. An included angle between the connecting plate and the second electrical connecting end 169 is greater than 90° and less than 180°. In this way, a distance between the second electrical connecting end and the first electrical connecting end may be increased.

Continue to refer to FIG. 33 and FIG. 34, in conjunction with FIG. 27. For example, three sequentially disposed connecting plates 168 are respectively denoted as a first connecting plate 168a, a second connecting plate 168b, and a third connecting plate 168c. The first electrical connecting ends 161 to which the first connecting plate 168a, the second connecting plate 168b, and the third connecting plate 168c are connected are respectively denoted as a first electrical terminal 161a, a second electrical terminal 161b, and a third electrical terminal 161c. The second electrical connecting ends to which the first connecting plate 168a, the second connecting plate 168b, and the third connecting plate 168c are connected are respectively denoted as a fourth electrical terminal 169a, a fifth electrical terminal 169b, and a sixth electrical terminal 169c. The first connecting plate 168a is inclined in a direction away from the first electrical terminal 161a and the second electrical terminal 161b. An inclination direction of the second connecting plate 168b and the third connecting plate 168c is the same as the inclination direction of the first connecting plate 168a. An included angle between the first connecting plate 168a and the fourth electrical terminal 169a is α1. An included angle between the second connecting plate 168b and the fifth electrical terminal 169b is α2. An included angle between the third connecting plate 168c and the sixth electrical terminal 169c is α3. α1 < α2 < α3. This arrangement can ensure safe distances between the three second electrical connecting ends 169, and reduce distances between the three first electrical connecting ends 161, thereby facilitating arrangement of the three-phase first lead-out wire 128.

Structures of the first electrical connecting ends 161 in the foregoing three embodiments may be implemented in any combination. Certainly, within a foreseeable scope of persons skilled in the art, reasonable modifications to the foregoing three embodiments may be made without creative efforts.

Refer to FIG. 1 to FIG. 23. In addition, the motor controller 300 may further include an electronic control housing 310, a control circuit board 360, a drive circuit board 370, and a bus electrical terminal 330. The drive circuit board 370 and the control circuit board 360 are located in the electronic control housing 310. The drive circuit board 370 is closer to the first motor 120 and the second motor 220 than the control circuit board 360. The drive circuit board 370 is electrically connected to the control circuit board 360, the bus electrical terminal 330, the first lead-out wire 128, and the second lead-out wire 228. The bus electrical terminal 330 is at least partially exposed outside the electronic control housing 310 for electrically connecting to a power supply of the vehicle through an electrical connector and a cable. When the bus electrical terminal 330 is connected to the power supply of the vehicle, electric energy is supplied to the drive board through the bus electrical terminal. Under control of the control circuit board 360, the drive circuit board 370 converts the electric energy and supplies converted electric energy to the first motor 120 sequentially through the first electrical connecting member 160 and the first lead-out wire 128, and to the second motor 220 sequentially through the second electrical connecting member 260 and the second lead-out wire 228, thereby controlling operation statuses of the first motor 120 and the second motor 220.

Continue to refer to FIG. 1 to FIG. 23. For example, a power device 371 is disposed on a side of the drive circuit board 370 facing the first motor 120 and the second motor 220. The power device 371 disposed corresponding to the first motor 120 may be denoted as a first power device 376. The power device 371 disposed corresponding to the second motor 220 may be denoted as a second power device 377. The first power device 376 is attached to the first heat sink 122 by using a heat-conducting structure or a heat-conducting medium such as heat-conducting silicone grease. The second power device 377 is attached to the second heat sink 222 by using a heat-conducting structure or a heat-conducting medium such as heat-conducting silicone grease. That is, the first power device 376 of the motor controller 300 is disposed corresponding to the first heat sink 122, and is attached to the first heat sink 122 by using the heat-conducting silicone grease, to exchange, through the first heat sink 122, heat generated by the first power device 376 during operation. That is, the second power device 377 of the motor controller 300 is disposed corresponding to the second heat sink 222, and is attached to the second heat sink 222 by using the heat-conducting structure or the heat-conducting medium such as the heat-conducting silicone grease, to exchange, through the second heat sink 222, heat generated by the second power device 377 during operation. The first power device 376 and the second power device 377 may be silicon carbide MOS transistors, or may be power switching transistors such as IGBT. Each of the first power device 376 and the second power device 377 may be a power assembly formed by a plurality of power switching transistors.

Refer to FIG. 1 to FIG. 23 again. In addition, the hydraulic pump of the present disclosure is a bidirectional pump. The hydraulic pump is provided with a first opening and a second opening in communication with each other. A hydraulic oil may flow from the first opening to the second opening, or may flow from the second opening to the first opening. The hydraulic energy supply device 600 may further include a detection assembly 140 and an adapter assembly. The detection assembly 140 may include a first sensor 142 and a second sensor 143. The first sensor 142 is adapted to detect an oil temperature at the first opening of the hydraulic pump. The second sensor 143 is adapted to detect an oil temperature at the second opening of the hydraulic pump. One end of the adapter assembly 149 is electrically connected to the first sensor 142 and the second sensor 143. The other end of the adapter assembly 149 is adapted to electrically connect to the motor controller 300. The oil temperature at the first opening of the hydraulic pump is detected by the first sensor 142, the oil temperature at the second opening of the hydraulic pump is detected by the second sensor 143, both the first sensor 142 and the second sensor 143 are connected to the same adapter assembly 149. This can simplify a circuit structure, facilitate mounting and maintenance, and be conducive to reducing sealing difficulty and costs.

For example, at least a portion of the detection assembly 140 is disposed between the hydraulic pump and the motor. The detection assembly 140 herein can make full use of space in the axial direction D2 of the hydraulic pump and the motor while ensuring that the oil temperature of the hydraulic pump can be detected, thereby facilitating shortening a sensing circuit.

For example, the adapter assembly 149 may include at least one of a first adapter board 144 and a second adapter board 148. The first adapter board 144 is located in the motor. The first adapter board 144 is electrically connected to the first sensor 142 and the second sensor 143. The second adapter board 148 is located outside the motor. The second adapter board 148 is adapted to detachably and electrically connect to the motor controller 300.

In an example, the adapter assembly 149 is only provided with a second adapter board 148. The second adapter board 148 may be connected to the motor controller 300 through an electrical connector such as a low-voltage plug-in portion. The second adapter board 148 may be electrically connected to the first sensor 142 and the second sensor 143 through g a cable, to implement a communication connection between the detection assembly 140 and the motor controller 300.

In another example, the adapter assembly 149 is only provided with a first adapter board 144. One end of the first adapter board 144 is electrically connected to the first sensor 142 and the second sensor 143, and the other end may be connected to the motor controller 300 through a cable. In this way, a communication connection between the detection assembly 140 and the motor controller 300 may also be implemented.

In a preferred example, the adapter assembly 149 includes a first adapter board 144, a second adapter board 148, and an adapter post 145. Both the first adapter board 144 and the second adapter board 148 are circuit boards. One end of the adapter post 145 is electrically connected to the first adapter board 144. The other end of the adapter post 145 is electrically connected to the second adapter board 148. The adapter post 145 may include an inner conductor and an outer hard shell. The outer hard shell is fixed to the first adapter board 144. One end of the inner conductor is electrically connected to the first adapter board 144. The other end of the inner conductor is electrically connected to the second adapter board 148. The second adapter board 148 may be fixedly connected relative to the motor.

Further, the first sensor 142 is a temperature sensor or a temperature and pressure sensor. The second sensor 143 is a temperature sensor or a temperature and pressure sensor. The first sensor 142 and the second sensor 143 may be a same sensor or may be different sensors.

For example, the hydraulic pump may include a pump housing. The pump housing may include a first connecting hole and a second connecting hole. The first sensor 142 is mounted into the first connecting hole. The second sensor 143 is mounted into the second connecting hole. By forming the first connecting hole and the second connecting hole in the pump housing, the detection assembly 140 can be mounted in the pump housing, which is conducive to improving accuracy of oil temperature detection at two openings of the hydraulic pump by the detection assembly 140.

In a hydraulic energy supply device 600 having two motors and two hydraulic pumps, the two motors are respectively a first motor 120 and a second motor 220 that are arranged coaxially and oppositely. The first motor 120 includes a first housing 121. The second motor 220 includes a second housing 221. The first housing 121 and the second housing 221 are fixedly connected to each other or are configured to be an integrated component. The two hydraulic pumps are located at outer ends of the two motors and are arranged coaxially with the motors. The two hydraulic pumps are respectively denoted as a first hydraulic pump 110 and a second hydraulic pump 210. The first hydraulic pump 110 is connected to the first motor 120. The second hydraulic pump 210 is connected to the second motor 220. A pump housing of the first hydraulic pump 110 is a first pump housing. A pump housing of the second hydraulic pump 210 is a second pump housing. The first pump housing is provided with a first connecting hole 113 and a third connecting hole 114. The first connecting hole 113 is configured to mount the first sensor 142. The third connecting hole 114 is configured to mount the second sensor 143. The second pump housing is provided with a second connecting hole 213 and a fourth connecting hole 214. The second connecting hole 213 is configured to mount the first sensor 142. The fourth connecting hole 214 is configured to mount the second sensor 143.

Optionally, the first connecting hole is parallel to the second connecting hole. This facilitates machining and assembly of the sensor.

In an illustrated example, both the first connecting hole and the second connecting hole are parallel to the axial direction D2 of the hydraulic pump.

For example, at least one of the first sensor 142 and the second sensor 143 abuts against the first adapter board 144. It may be understood that the first sensor 142 abuts against the first adapter board 144, and the second sensor 143 is connected to the first adapter board 144 in other manners. Alternatively, it may be understood that the first sensor 142 is connected to the first adapter board 144 in other manners, and the second sensor 143 abuts against the first adapter board 144. Alternatively, it may be understood that both the first sensor 142 and the second sensor 143 abut against the first adapter board 144. In this way, the sensors are simpler and more convenient to mount, and assembly efficiency is improved.

Further, an end portion of at least one of the first sensor 142 and the second sensor 143 is provided with a spring. The spring abuts against the first adapter board 144. Either of the first sensor 142 and the second sensor 143 abuts against the first adapter board 144 through the spring, or both the first sensor 142 and the second sensor 143 abut against the first adapter board 144 through the spring. During mounting, abutting of the sensor and the first adapter board 144 may be implemented by a pre-tightening force of the spring, which improves abutting reliability, and is conducive to preventing poor electrical contact caused by factors such as jolt, vibration, or the like.

For example, the motor may include a housing. The housing is provided with a temperature sensing via hole. The temperature sensing via holes at least partially extend to the outside of the housing in a direction intersecting with the axial direction D2 of the motor. The adapter assembly 149 is mounted into the temperature sensing via hole. With arrangement of the temperature sensing via hole, at least a portion of the adapter assembly 149 can be accommodated, which reduces space occupied by the adapter assembly 149. In addition, the adapter assembly 149 can be fixed and protected.

In an illustrated example, the temperature sensing via hole extends in a radial direction of the motor to penetrate through the housing. That is, the temperature sensing via hole penetrates into an inner cavity of the housing. The foregoing first connecting hole and the foregoing second connecting hole may communicate with an inner cavity of the housing in the axial direction D2 of the motor. Therefore, the first sensor 142 and the second sensor 143 can be conveniently connected to the adapter assembly 149 in the inner cavity of the motor.

Refer to FIG. 1 to FIG. 23. In a hydraulic energy supply device 600 having two motors and two hydraulic pumps, the two motors are respectively a first motor 120 and a second motor 220 that are arranged coaxially and oppositely. The first motor 120 includes a first housing 121. The second motor 220 includes a second housing 221. The first housing 121 and the second housing 221 are fixedly connected to each other or are configured to be an integrated component. In an embodiment in which the first housing 121 and the second housing 221 are assembled together by welding or the like, the first housing 121 is provided with a first via hole 121e. The second housing 221 is provided with a third via hole 221e. An adapter assembly 149 is mounted into each of the first via hole 121e and the third via hole 221e. In an embodiment in which the first housing 121 and the second housing 221 are configured to be an integrated component or an integrated housing 500, the integrated housing 500 is provided with a first via hole 500g and a third via hole 500o. An adapter assembly 149 is mounted into each of the first via hole 500g and the third via hole 500o.

In the foregoing embodiment, a flow channel is formed in the housing. The flow channel and a portion of the housing form a heat sink. The heat sink is arranged corresponding to the motor controller to be adapted to cool power devices in the motor controller. The temperature sensing via holes and the flow channel are both located on a same side of the housing and are spaced apart from each other. In the axial direction D2 of the motor, the temperature sensing via holes are located at ends that are of the housings of the two motors and that are away from each other, that is, located at outer ends of the housings. The outer end of the housing is configured to connect to the pump housing of the hydraulic pump. This is conducive to reducing a distance between the adapter assembly and the temperature sensor, thereby facilitating mounting of the two.

In addition, the housing further includes a motor sensing via hole. The hydraulic energy supply device 600 may further include a motor sensor (not shown). A wire outgoing end of the motor sensor at least partially passes through the motor sensing via hole. A detection end of the motor sensor is connected to a winding. The motor sensor is connected to the motor controller. The motor sensor is configured to detect a temperature of the winding, so that the vehicle controller can regulate an operation status of the heat sink based on the temperature of the winding. For example, when the temperature of the winding is relatively high, a vehicle control apparatus may accelerate a circulation speed of a cooling circuit of the heat sink, thereby improving heat dissipation efficiency. When the temperature of the winding is low, the vehicle controller can slow down the circulation speed of the cooling circuit of the heat sink, thereby reducing energy consumption. In an embodiment in which the first housing and the second housing are assembled together by welding or the like, the first housing is provided with a second via hole 121s. The second housing is provided with a fourth via hole 221s. A motor sensor is mounted into each of the second via hole 121s and the fourth via hole 221s. In an embodiment in which the first housing and the second housing are configured to be an integrated component or an integrated housing, an integrated housing 500 is provided with a second via hole 500t and a fourth via hole 500u. A motor sensor is mounted into each of the second via hole 500t and the fourth via hole 500u.

For example, the motor sensing via hole extends to the outside in the radial direction of the motor. The motor sensing via hole and the temperature sensing via hole are arranged side by side on a same side of the housing. Furthermore, the motor sensing via hole and the flow channel are spaced apart from each other. This facilitates assembly of the sensor, is conducive to simplifying a circuit and improving space utilization.

The detection assemblies 140 according to the present disclosure are disposed at the first motor pump 100 and the second motor pump 200. The detection assembly 140 is configured to detect an oil temperature of the first hydraulic pump 110 and/or the second hydraulic pump 210. The motor controller 300 may further include a signal plug-in connector 320. The signal plug-in connector 320 is connected to the electronic control housing 310. The control circuit board 360 is electrically connected to the signal plug-in connector 320 and the detection assembly 140. The signal plug-in connector 320 is adapted to electrically connect to the vehicle control apparatus. The detection assemblies 140 may detect the oil temperatures of the first hydraulic pump 110 and the second hydraulic pump 210 and send the oil temperatures to the control circuit board 360. The control circuit board 360 transmits the oil temperatures to the vehicle control apparatus via the signal plug-in connector 320. The control circuit board 360 may further receive a control instruction from the control apparatus, and control operation statuses of the first motor 120 and the second motor 220 according to the control instruction, thereby indirectly controlling operation statuses of the first hydraulic pump 110 and the second hydraulic pump 210.

The detection assemblies 140 are disposed between the first motor 120 and the first hydraulic pump 110 as well as between the second motor 220 and the second hydraulic pump 210. The two detection assemblies 140 may be the same. The following description illustrates an example in which the detection assembly 140 is applied to the first motor pump 100.

Refer to FIG. 1 to FIG. 19 again. The detection assembly 140 according to the present disclosure is disposed between the first hydraulic pump 110 or the first hydraulic pump 110 and the first motor 120. The detection assembly 140 may include a first sensor 142 and a second sensor 143. The first hydraulic pump 110 is a bidirectional hydraulic pump and includes a first opening and a second opening adapted to circulate oil. The first sensor 142 is configured to detect an oil temperature at the first opening of the first hydraulic pump 110. The second sensor 143 is configured to detect an oil temperature at the second opening of the first hydraulic pump 110. The hydraulic energy supply device 600 may further include an adapter assembly 149. One end of the adapter assembly 149 is electrically connected to the first sensor 142 and the second sensor 143. The other end of the adapter assembly 149 is configured to electrically connect to the motor controller 300 to send the detected oil temperature to the motor controller 300. By connecting the first sensor 142 and the second sensor 143 through the adapter assembly 149, the adapter assembly 149 can transmit the oil temperatures detected by the first sensor 142 and the second sensor 143 to the motor controller 300.

Similarly, the detection assembly 140 is further disposed between the second hydraulic pump 210 or the second hydraulic pump 210 and the second motor 220. The second hydraulic pump 210 is a bidirectional hydraulic pump and includes a first opening and a second opening adapted to circulate oil. The first sensor 142 is configured to detect an oil temperature at the first opening of the second hydraulic pump 210. The second sensor 143 is configured to detect an oil temperature at the second opening of the second hydraulic pump 210. The second motor 220 is provided with an adapter assembly 149. One end of the adapter assembly 149 is electrically connected to the first sensor 142 and the second sensor 143. The other end of the adapter assembly 149 is configured to electrically connect to the motor controller 300 to send the detected oil temperature to the motor controller 300. By connecting the first sensor 142 and the second sensor 143 through the adapter assembly 149, the adapter assembly 149 can transmit the oil temperatures detected by the first sensor 142 and the second sensor 143 to the motor controller 300.

This can reduce space occupied by the detection assembly 140, simplify a circuit structure, and be conducive to reducing sealing difficulty, saving costs, and improving compactness of a motor pump structure.

Refer to FIG. 6 and FIG. 16. For example, the first hydraulic pump 110 may include a first pump housing (not labeled). The first pump housing is provided with a first connecting hole 113 and a third connecting hole 114. The first connecting hole 113 and the third connecting hole 114 each extend in the axial direction D2 of the first pump housing to an end face of the first pump housing facing the first motor 120. The first sensor 142 is mounted into the first connecting hole 113. The second sensor 143 is mounted into the third connecting hole 114. Springs (not shown) are disposed at ends that are of the first sensor and the second sensor and that are close to the adapter assembly 149. This arrangement has the advantages that the first sensor 142 may be directly mounted into the first connecting hole 113, and the second sensor 143 may be directly mounted into the third connecting hole 114. In addition, the first sensor 142 and the second sensor 143 abut against the adapter assembly 149 through the springs, which is relatively convenient to mount. The first housing 121 is provided with a first via hole 121e. The first via hole 121e extends to the inside and the outside of the first housing 121 in a direction intersecting with the axial direction D2 of the first motor 120. The adapter assembly 149 passes through the first via hole 121e. Accordingly, refer to FIG. 7 and FIG. 17. The second hydraulic pump 210 may include a second pump housing. The second pump housing is provided with a second connecting hole 213 and a fourth connecting hole 214. The second connecting hole 213 and the fourth connecting hole 214 each extend in the axial direction D2 of the second pump housing to an end face of the second pump housing facing the second motor 220. The first sensor 142 is connected to the second connecting hole 213. The second sensor 143 is connected to the fourth connecting hole 214. The second housing 221 is provided with a third via hole 221e. The third via hole 221e extends to the inside and the outside of the second housing 221 in a direction intersecting with the axial direction D2 of the second motor 220. The adapter assembly 149 passes through the third via hole 221e.

Further, refer to FIG. 6 and FIG. 16. Both the first connecting hole 113 and the third connecting hole 114 penetrate through the first pump housing in the axial direction D2 of the first pump housing. The first motor pump 100 may further include two first seal rings 141. The first seal rings 141 are hermetically connected between the first sensor 142 and the first connecting hole 113 as well as between the second sensor 143 and the third connecting hole 114, respectively. This facilitates assembly of the first sensor 142 into the first connecting hole 113 and assembly of the second sensor 143 into the third connecting hole 114. With arrangement of the first seal rings 141, sealing performance between the first sensor 142 and the first connecting hole 113 as well as sealing performance between the second sensor 143 and the third connecting hole 114 are improved. Accordingly, refer to FIG. 7 and FIG. 17. Both the second connecting hole 213 and the fourth connecting hole 214 penetrate through the first pump housing in the axial direction D2 of the first pump housing. The second motor pump 200 may further include two second seal rings 241. The second seal rings 241 are hermetically connected between the first sensor 142 and the second connecting hole 213 as well as between the second sensor 143 and the fourth connecting hole 214, respectively. This facilitates assembly of the first sensor 142 into the second connecting hole 213 and assembly of the second sensor 143 into the fourth connecting hole 214. With arrangement of the second seal rings 241, sealing performance between the first sensor 142 and the second connecting hole 213 as well as sealing performance between the second sensor 143 and the fourth connecting hole 214 are improved.

Refer to FIG. 6 to FIG. 8, FIG. 16 to FIG. 18, and FIG. 23 and FIG. 24. For example, the adapter assembly 149 may include a first adapter board 144, an adapter post 145, and a second adapter board 148. The first adapter board 144 is electrically connected to the first sensor 142 and the second sensor 143. Specifically, the first sensor 142 and the second sensor 143 can abut against the first adapter board 144 through springs. The adapter post 145 passes through the first via hole 121e. One end of the adapter post 145 is electrically connected to the first adapter board 144. The second adapter board 148 is electrically connected to the other end of the adapter post 145. The second adapter board 148 is adapted to detachably and electrically connect to the motor controller 300 through an electrical connector such as a low-voltage plug-in terminal. When the adapter assembly 149 is mounted to the first motor pump 100, the second adapter board 148 is located outside the first motor 120. When the adapter assembly 149 is mounted to the second motor pump 200, the second adapter board 148 is located outside the second motor 220.

Refer to FIG. 6 to FIG. 8, and FIG. 16 to FIG. 18. In addition, the first motor pump 100 may further include a second seal ring 146, and the second seal ring 146 is hermetically connected between the adapter assembly 149 and the first via hole 121e. In this way, sealing performance between the adapter assembly 149 and the first via hole 121e can be improved. Accordingly, the second motor pump 200 may further include a second seal ring 146, and the second seal ring 146 is hermetically connected between the adapter assembly 149 and the third via hole 221e. In this way, sealing performance between the adapter assembly 149 and the third via hole 221e can be improved.

Refer to FIG. 6 to FIG. 8, and FIG. 16 to FIG. 18 again. In addition, the first motor pump 100 may further include a first end cover assembly 130. The first end cover assembly 130 is connected to an end portion of the first hydraulic pump 110 away from the first motor 120 in the axial direction D2 of the first hydraulic pump 110. In this way, the first motor 120, the first hydraulic pump 110, and the first end cover assembly 130 form the first motor pump 100. Accordingly, the second motor pump 200 may include a second end cover assembly 230. The second end cover assembly 230 is connected to an end portion of the second hydraulic pump 210 away from the second motor 220 in the axial direction D2 of the second hydraulic pump 210. In this way, the second motor 220, the second hydraulic pump 210, and the second end cover assembly 230 form the second motor pump 200.

Refer to FIG. 1, FIG. 8, FIG. 10, FIG. 11, FIG. 18, FIG. 19, FIG. 20, FIG. 24, and FIG. 25. In addition, the motor controller 300 may further include a breather valve 340. The electronic control housing 310 is connected to the first housing 121 and the second housing 221. The breather valve 340 is connected to the electronic control housing 310. The breather valve 340 communicates with the inside and the outside of the electronic control housing 310, to balance pressures inside and outside the electronic control housing 310. Generally, certain air tightness needs to be ensured between the electronic control housing 310, the first housing 121, and the second housing 221. When the motor controller 300 operates, a certain amount of heat is generated in the motor controller 300, so that the pressure in the housing of the motor controller 300 changes. With arrangement of the breather valve 340 to balance the pressure inside and outside the electronic control housing 310, an operation status of the motor controller 300 can be improved.

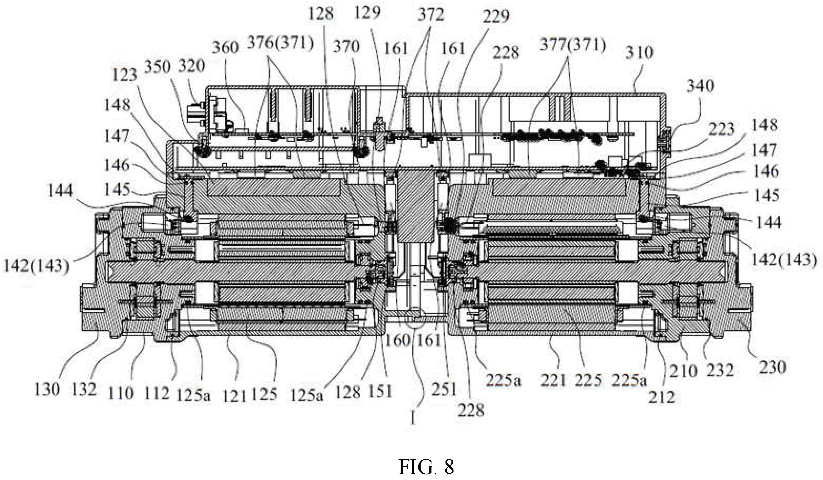

Refer to FIG. 8, FIG. 10, FIG. 18, FIG. 19, FIG. 24, and FIG. 25. In addition, the motor controller 300 may further include a shield plate 350. The shield plate 350 is connected between the control circuit board 360 and the drive circuit board 370 in the first direction D1, to shield, between the control circuit board 360 and the drive circuit board 370, an interference signal generated by the drive circuit board 370.

As shown in FIG. 1 to FIG. 19, a hydraulic energy supply device 600 according to an embodiment of the present disclosure may include a first motor pump 100 and a second motor pump 200 disposed oppositely in the axial direction D2, and a motor controller 300. The axial direction D2 herein is parallel to an axis of the first motor pump 100 and an axis of the second motor pump 200. The first motor pump 100 includes a first motor 120, a first hydraulic pump 110, and a first end cover assembly 130 that are sequentially arranged in the axial direction D2. The first motor 120 is closer to the second motor pump 200. The first end cover assembly 130 is configured to mount to a chassis of the vehicle. The second motor pump 200 includes a second motor 220, a second hydraulic pump 210, and a second end cover assembly 230 that are sequentially arranged in the axial direction D2. The second motor 220 is closer to the second motor pump 200. The second end cover assembly 230 is configured to mount to the chassis of the vehicle. The motor controller 300 is connected to the first motor pump 100 and the second motor pump 200. When the hydraulic energy supply device 600 is mounted to the vehicle, the motor controller 300 is located above the first motor pump 100 and the second motor pump 200. The motor controller 300 is provided with a signal plug-in connector 320, a bus electrical terminal 330, and a breather valve 340. The signal plug-in connector 320 is configured to communicate with the entire vehicle. The bus electrical terminal 330 is configured to supply power to the motor. The breather valve 340 is configured to balance a pressure difference in the electronic control housing 310.

Refer to FIG. 1 to FIG. 19. An assembly process of the first motor pump 100 may include the following steps.

Step 1: In a first resolver via hole 121h at an inner end of the first housing 121, a first resolver body 153 on which a first resolver seal ring 151 is mounted is assembled by using a first resolver snap spring 152. When the first housing 121 is connected to the second housing 221, the inner end of the first housing 121 is closer to the second housing 221 than an outer end of the first housing 121.

Step 2: The first electrical connecting member 160 is mounted at an end portion of the inner end of the first housing 121.

Step 3: The adapter post 145 on which the second seal ring 146 and the first adapter board 144 are mounted is mounted into the first via hole 121e. The adapter post 145 is fixed to the first housing 121 by using the fixing plate 147. The second adapter board 148 is welded to a signal connection terminal such as a signal pin of the adapter post 145. The second adapter board 148 is provided with a plug-in electrical connector configured to electrically connect to the control circuit board 360.

Step 4: The first motor body 125 is mounted into the first housing 121 from the outer end of the first housing 121. After the first lead-out wire 128 on the first motor body 125 passes through a first wire hole 121g of the first housing 121 and a first insulating seal member 129 is mounted, the first lead-out wire 128 is connected to the first electrical connecting end 161 of the first electrical connecting member 160.

Step 5: The temperature sensor on which the first seal ring 141 is mounted is mounted into the first connecting hole 113 of the first hydraulic pump 110.

Step 6: The first hydraulic pump 110 is hermetically assembled to the end portion of the outer end of the first housing 121. Locating can be implemented through mutual cooperation between a first pump housing limiting hole 121n formed in the end portion of the outer end of the first housing 121 and a first pump housing locating pin 111 at an end portion of the first hydraulic pump 110.

Step 7: The first end cover assembly 130 is hermetically sealed at an end portion of the first hydraulic pump 110 away from the first housing 121. Therefore, assembly of the first motor pump 100 is completed.

In other words, the mounting process of the first motor pump 100 may include the following operations. The first resolver body 153 with the first resolver seal ring 151 is mounted at an end portion of the first motor pump 100 facing the second motor pump 200, and is fixed by using the first resolver snap spring 152. At the joint between the first motor pump 100 and the second motor pump 200, the first electrical connecting member 160 corresponding to the first motor pump 100 is mounted. After passing through the first insulating seal member 129, the first lead-out wire 128 is connected to the first electrical connecting end 161 on the first electrical connecting member 160 by means of abutting, plugging, snap fitting, or the like. The second electrical connecting end 169 of the first electrical connecting member 160 may be connected to an alternating current terminal 372 on the drive circuit board 370 by means of plugging, or the like. The alternating current terminal 372 may be an alternating current plug-in connector, and is adapted to be in plug-in connection with the second electrical connecting end 169. That is, the second electrical connecting end 169 is inserted into and electrically connected to the alternating current plug-in connector on the drive board. This connection manner is similar to a connection between a plug and a socket of a household appliance, and is conducive to production and assembly. After the first motor body 125 is mounted from an end of the first motor pump 100 away from the second motor pump 200 in the axial direction D2, the first hydraulic pump 110 on which a first pump housing seal ring 112 and a first motor body seal ring 125a are mounted is mounted at an end portion of the first housing 121 away from the first motor pump 100 in the axial direction D2. Finally, the first end cover assembly 130 is mounted at an end portion of the first hydraulic pump 110 away from the first hydraulic pump 110 in the axial direction D2. The first end cover assembly 130 herein may include a first end cover 131 and a first end cover seal ring 132. The first end cover 131 may be fastened to the first pump housing of the first hydraulic pump 110 by a fastener such as a bolt. The first end cover seal ring 132 is disposed between the first hydraulic pump 110 and the first end cover 131. The first end cover 131 is provided with a first cantilever 131a extending toward two sides in a direction intersecting with the axis of the first motor pump 100. Specifically, the first cantilever 131a may be a connecting lug.

There may be two temperature sensors assembled on the first motor pump 100. One of the two temperature sensors is configured to detect a temperature of the first motor 120, and the other is configured to detect a temperature of the first hydraulic pump 110. Temperature signals detected by the two temperature sensors may be sent to the control circuit board 360 through the same adapter post 145 and the second adapter board 148. The sensor configured to detect the temperature of the first motor 120 may also be disposed side by side with the adapter post 145. This can save space, and reduce sealing costs and signal adapter costs. The two temperature sensors may be the same or different.

The first resolver seal ring 151, the first resolver snap spring 152, and the first resolver body 153 form a portion of the first resolver assembly 150.

Refer to FIG. 1 to FIG. 19. An assembly process of the second motor pump 200 may include the following steps.

Step 1: In a second resolver via hole 221h at an inner end of the second housing 221, a second resolver body 253 on which a second resolver seal ring 251 is mounted is assembled by using a second resolver snap spring 252. When the second housing 221 is connected to the second housing 221, the inner end of the second housing 221 is closer to the first housing 121 than an outer end of the second housing 221.

Step 2: The second electrical connecting member 260 is mounted at an end portion of the inner end of the second housing 221.

Step 3: The adapter post 145 on which the second seal ring 146 and the first adapter board 144 are mounted is mounted into a third via hole 221e. The adapter post 145 is fixed to the second housing 221 by using the fixing plate 147. The second adapter board 148 is welded to a signal connection terminal such as a signal pin of the adapter post 145. The second adapter board 148 is provided with a plug-in electrical connector configured to electrically connect to the control circuit board 360.

Step 4: The second motor body 225 is mounted into the second housing 221 from the outer end of the second housing 221. After the second lead-out wire 228 on the second motor body 225 passes through a second wire hole 221g of the second housing 221 and the second insulating seal member 229 is mounted, the second lead-out wire 228 is connected to the second electrical terminal of the second electrical connecting member 260.

Step 5: The second temperature sensor with a second first seal ring 141 is mounted into the second connecting hole 213 of the second hydraulic pump 210.

Step 6: The second hydraulic pump 210 is hermetically assembled to an end portion of the outer end of the second housing 221. Locating can be implemented through mutual cooperation between a second pump housing limiting hole 221n formed in the end portion of the outer end of the second housing 221 and a second pump housing locating pin 211 at an end portion of the second hydraulic pump 210.

Step 7: The second end cover assembly 230 is hermetically sealed at an end portion of the second hydraulic pump 210 away from the second housing 221. Therefore, assembly of the second motor pump 200 is completed.

In other words, the mounting process of the second motor pump 200 may include the following operations. The second resolver body 253 with the second resolver seal ring 251 is mounted at an end of the second motor pump 200 facing the first motor pump 100, and is fixed by using the second resolver snap spring 252. At the joint between the first motor pump 100 and the second motor pump 200, the second electrical connecting member 260 corresponding to the second motor pump 200 is mounted. After passing through the second insulating seal member 229, the second lead-out wire 228 is connected to the second electrical terminal on the second electrical connecting member 260 by means of abutting, plugging, snap fitting or the like. The fifth electrical terminal of the second electrical connecting member 260 may be connected to an alternating current terminal 372 on the drive circuit board 370 by means of plugging or the like. The alternating current terminal 372 may be an alternating current plug-in connector, and is adapted to be in plug-in connection with the fifth electrical terminal. That is, the fifth electrical terminal is inserted into and electrically connected to the alternating current plug-in connector on the drive board. This connection manner is similar to a connection between a plug and a socket of a household appliance, and is conducive to production and assembly. After the second motor body 225 is mounted from an end of the second motor pump 200 away from the first motor pump 100 in the axial direction D2, the second hydraulic pump 210 on which a second pump housing seal ring 212 and a second pump body seal ring 225a are mounted is mounted at an end portion of the second housing 221 away from the second motor pump 200 in the axial direction D2. Finally, the second end cover assembly 230 is mounted at an end portion of the second hydraulic pump 210 away from the second hydraulic pump 210 in the axial direction D2. The second end cover assembly 230 herein may include a second end cover 231 and a seal ring 232 of the second end cover 231. The second end cover 231 may be fastened to the second pump housing of the second hydraulic pump 210 by a fastener such as a bolt. The seal ring 232 of the second end cover 231 is disposed between the second hydraulic pump 210 and the second end cover 231. The second end cover 231 is provided with a second cantilever 231a extending toward two sides in a direction intersecting with the axis of the second motor pump 200. Specifically, the second cantilever 231a may be a connecting lug. A structure of the second cantilever 231a may be the same as or different from that of the first cantilever 131a.

There may be two second temperature sensors assembled on the second motor pump 200. One of the two second temperature sensors is configured to detect a temperature of the second motor 220, and the other is configured to detect a temperature of the second hydraulic pump 210. Temperature signals detected by the two second temperature sensors may be sent to the control circuit board 360 through the same adapter post 145 and the second adapter board 148. The sensor configured to detect the temperature of the first motor 120 may also be disposed side by side with the adapter post 145. This can save space, and reduce sealing costs and signal adapter costs. The two second temperature sensors may be the same or different.

The second resolver seal ring 251, the second resolver snap spring 252, and the second resolver body 253 form a portion of the second resolver assembly 250.

FIG. 1 to FIG. 19 are diagrams of an assembly structure of the hydraulic energy supply device 600 according to one embodiment of the present disclosure. After the first motor 120 and the second motor 220 are assembled to form an integrated dual-motor, the drive circuit board 370 is mounted on an upper portion of the integrated dual-motor and separately electrically connected to the first electrical connecting member 160 and the second electrical connecting member 260. In addition, the power device 371 on the drive circuit board 370 is closely attached to the first heat sink 122 and the second heat sink 222 by using heat-conducting silicone grease. Then, after the control circuit board 360 on which the signal plug-in connector 320 is mounted is mounted into the electronic control housing 310, the shield plate 350 is mounted to shield a region that is on the control circuit board 360 and that is easily disturbed to improve electromagnetic compatibility. After the signal connection terminal of the second adapter board 148 and the drive circuit board 370 are connected to the control circuit board 360, the electronic control housing 310 and the integrated dual-motor are hermetically assembled together. Finally, the bus electrical terminal 330 is mounted, and the copper busbar of the bus electrical terminal 330 is inserted into the direct current terminal 373 on the drive circuit board 370. The direct current terminal 373 herein may be a direct current plug-in connector. This connection manner of the bus electrical terminal 330 and the direct current plug-in connector is similar to the above-mentioned connection manner of the first electrical connecting member 160 or the second electrical connecting member 260 and the control circuit board 360, and is similar to the connection manner of the plug and the socket of the household appliance, which is simple to assemble and easy to operate. In addition, three-phase copper busbars of the first electrical connecting member 160 and the second electrical connecting member 260 are placed vertically, which facilitates heat dissipation of the copper busbars. The three-phase copper busbars herein may be understood as the first electrical connecting ends 161 and the second electrical connecting ends 169 of the first electrical connecting member 160 and the second electrical connecting member 260.

FIG. 8 is a diagram of an internal structure of the hydraulic energy supply device 600 according to one embodiment of the present disclosure. An internal layout of the motor controller 300 and a relationship between the first heat sink 122, the second heat sink 222, and the power device 371 are shown. Structures of the first motor 120 and the second motor 220 may be the same, and structures of the first heat sink 122 and the second heat sink 222 may be the same. For ease of description herein, the first motor 120 and the second motor 220 are collectively referred to as a motor, and the first heat sink 122 and the second heat sink 222 are collectively referred to as a heat sink. The heat sink may be a heat pipe, or may be a liquid-cooled heat dissipation assembly that can circulate a heat exchange medium. Power devices 371 are disposed above the heat sinks of the two motors. The power device 371 herein may be a power device such as an IGBT power device or a silicon carbide MOS transistor. The heat sink is deeply buried into the housing of the motor. Furthermore, an interior of the housing also contains oil that can circulate. In this way, the power device 371 can achieve good heat dissipation by using the heat sink, so that a temperature condition of the power device 371 in use is more suitable. The drive circuit board 370,the shield plate 350, the control circuit board 360, and the electronic control housing 310 are disposed above the power device 371. The signal plug-in connector 320 of the control circuit board 360 passes through the electronic control housing 310 and extends to the outside. The electronic control housing 310 is further provided with the breather valve 340 for preventing condensation and a heat dissipation balance pressure difference. The second adapter board 148 and the fixing plate 147 are further disposed below two ends of the control circuit board 360 in the second direction D2. The adapter post 145 on which the second seal ring 146 and the first adapter board 144 are mounted is put into the temperature sensing via holes 121e and 221e. The first adapter board 144 is mounted at the other end of the adapter post 145. The first adapter board 144 is electrically connected to the first sensor 142 and the second sensor 143 by springs of the first sensor 142 and the second sensor 143. Each motor pump is provided with two types of sensors for temperature detection. One type includes the first sensor 142 and the second sensor 143. The first sensor 142 and the second sensor 143 are sensors configured to detect oil temperatures at an inlet and an outlet of the hydraulic pump. Another type of sensors may be referred to as the motor sensor. The motor sensor may be a motor NTC temperature sensor, configured to detect a temperature of the winding of the motor. Temperature signals detected by the first sensor 142 and the second sensor 143 are transmitted to the second adapter board 148 through the first adapter board 144 and the adapter post 145, and then transmitted to the control circuit board 360 through the second adapter board 148., which can save space, and reduce sealing costs and signal adapter costs.

Refer to FIG. 1 to FIG. 19. The hydraulic energy supply device 600 according to the present disclosure achieves a firmer engagement between the first housing 121 and the second housing 221 by friction welding the two motors. Alternatively, the housings of the two motors are integrally molded, which not only enhances structural firmness, but also can improve sealing performance and assembly efficiency. The first heat sink 122 is added to the first housing 121 and the second heat sink 222 is added to the second housing 221, so that heat dissipation effect of the power device 371 of the motor controller 300 can be improved, and therefore, higher power is output by the motor with a same volume. In addition, the first electrical connecting members 160 and the second electrical connecting members 260 in three embodiments are provided, so that a connection problem between the lead-out wire of the motor winding and the motor controller 300 can be well resolved. The detection assembly 140 is disposed to detect temperature data, where the oil temperatures at the inlet and outlet of the hydraulic pump are detected by the first sensor 142 and the second sensor 143, and the temperature of the winding of the motor is detected by the motor NTC temperature sensor. After the detection assembly 140 is combined with an adapter assembly 149 including the first adapter board 144, the adapter post 145, the second seal ring 146, the fixing plate 147, and the second adapter board 148, a plug-in connector that is convenient for plugging and mounting can be formed. In addition, a first adapter assembly 149 of the first motor pump 100 and a second adapter assembly 149 of the second motor pump 200 are both connected to the control circuit board 360, so that a circuit can be saved. Plug-in connectors are used between the direct current bus electrical terminal 330 and the drive circuit board 370 as well as between the first electrical connecting member 160, the second electrical connecting member 260 and the drive circuit board 370, which can save assembly space and facilitate automatic production. In addition, the connection copper busbars of the first electrical connecting member 160 and the second electrical connecting member 260 are arranged in a three-dimensional configuration, so that heat dissipation effect can be improved.

The present disclosure further provides a chassis system. The chassis system may include a shock absorber and the foregoing hydraulic energy supply device 600. The hydraulic energy supply device 600 is in fluid communication with the shock absorber. The hydraulic energy supply device 600 is configured to control active vibration damping of the shock absorber.

In the chassis system according to the present disclosure, damping effect of the chassis system can be improved by applying the foregoing hydraulic energy supply device 600.

The present disclosure further provides a vehicle. The vehicle may include the foregoing hydraulic energy supply device 600, or may include the foregoing chassis system.

In the vehicle according to the present disclosure, application of the foregoing hydraulic energy supply device 600 or the foregoing chassis system is conducive to improving stability of the vehicle and comfort of occupants during traveling.

Refer to FIG. 1 to FIG. 25. For example, the vehicle may further include an air conditioner. The air conditioner is in fluid communication with the first flow channels 121o, 500i and the second flow channels 221o, 500q to share a heat exchange medium with the first flow channels 121o, 500i and the second flow channels 221o, 500q. Configuring the hydraulic energy supply device 600 to be in fluid communication with the air conditioner and to share the heat exchange medium is conducive to simplifying the structure and reducing costs.

In an example, the second opening 121q is in fluid communication with the third opening 221p. The air conditioner is connected in series between the first opening 121p and the fourth opening 221q through a pipeline. That is, the first flow channels 121o and 500i, the second flow channels 221o and 500q, and the air conditioner are sequentially connected in series.

In another example, the air conditioner is connected in series between the first opening 121p and the second opening 121q through a pipeline. The air conditioner is connected in series between the third opening 221p and the fourth opening 221q through a pipeline. That is, the first flow channels 121o, 500i and the second flow channels 221o, 500q are connected in parallel to the air conditioner.

Unless otherwise defined, technical and scientific terms used herein have the same meanings as commonly understood by persons skilled in the art to which the present disclosure pertains. Terms used herein are merely intended to describe specific embodiments, but are not intended to limit the present disclosure. Terms such as "disposed" as used herein may indicate either that one component is attached directly to another component, or that one component is attached to another component through an intermediate component. A feature described in one implementation in this specification may be applied to another implementation alone or in combination with another feature, unless the feature is not applicable in the other implementation or otherwise specified.

The present disclosure has been described by the foregoing implementations, but it should be understood that the foregoing implementations are provided for purposes of illustration and description only, and are not intended to limit the present disclosure to the scope of the described implementations. It will be understood by persons skilled in the art that various variations and modifications may be made in accordance with the teachings of the present disclosure, and that these variations and modifications fall within the scope claimed in the present disclosure.

## Claims

1. A motor assembly (700), wherein the motor assembly (700) comprises:
a motor controller (300); and
a motor (120, 220), the motor (120, 220) being connected to an outer side of the motor controller (300), the motor (120, 220) comprising a housing (121, 221), and a flow channel (121o, 221o) being formed in a portion of the housing (121, 221) facing the motor controller (300).

2. The motor assembly (700) according to claim 1, wherein
the housing (121, 221) comprises:
a housing body (121a, 221a), a mounting groove (121b, 221b) being formed in a portion of the housing body (121a, 221a) facing the motor controller (300);
a flow channel board (124, 224), the flow channel board (124, 224) being connected to the mounting groove (121b, 221b) to form a heat dissipation cavity (121t, 221t), and the flow channel board (124, 224) supporting the motor controller (300); and
a flow guide rib (121c, 221c), the flow guide rib (121c, 221c) being connected to the heat dissipation cavity (121t, 221t), to define the heat dissipation cavity (121t, 221t) as the flow channel (121o, 221o).

3. The motor assembly (700) according to claim 2, wherein
the flow channel board (124, 224) comprises an auxiliary heat dissipation body (124a, 224a) extending to the flow channel (121o, 221o).

4. The motor assembly (700) according to claim 3, wherein
the auxiliary heat dissipation body (124a, 224a) is configured to be a heat dissipation pin, the flow channel board (124, 224, 502) comprises a plurality of heat dissipation pins, and each of the heat dissipation pins are spaced apart along an arrangement path adapted to the flow channel (121o, 221o).

5. The motor assembly (700) according to claim 2, wherein
the flow guide rib (121c, 221c) and the housing body (121a, 221a) are integrally formed.

6. The motor assembly (700) according to any one of claims 1 to 5, wherein
the motor assembly (700) comprises two motors (120, 220), the two motors (120, 220) are arranged coaxially and oppositely, and the housings (121, 221) of the two motors (120, 220) are connected to each other.

7. The motor assembly (700) according to claim 6, wherein
the two housings (121, 221) are a first housing (121) and a second housing (221) respectively, wherein
a recessed platform (121j) is formed at an end portion of the first housing (121) close to the second housing (221); and
a boss (221j) is formed at an end portion of the second housing (221) close to the first housing (121), the boss (221j) is adapted to the recessed platform (121j), and the boss (221j) is welded and fixed to the recessed platform (121j), to fix the second housing (221) to the first housing (121).

8. The motor assembly (700) according to claim 6 or 7, wherein
the two housings (121, 221) are an integrated component.

9. The motor assembly (700) according to any one of claims 6 to 8, wherein
an accommodating groove (400) is formed in a joint of the two housings (121, 221), a notch of the accommodating groove (400) faces the motor controller (300), and the accommodating groove (400) is configured to at least accommodate a capacitor (375) of the motor controller (300).

10. The motor assembly (700) according to claim 9, wherein the two housings (121, 221) are respectively denoted as a first housing (121) and a second housing (221), a flow channel formed in the first housing (121) is a first flow channel (121o), a flow channel formed in the second housing (221) is a second flow channel (221o), the first flow channel (121o) and the second flow channel (221o) are spaced apart by the accommodating groove (400), and the first flow channel (121o) and the second flow channel (221o) communicate with each other at a joint of the first housing (121) and the second housing (221).

11. The motor assembly (700) according to any one of claims 1 to 10, wherein
the motor controller (300) comprises an electronic control housing (310) and a breather valve (340), the electronic control housing (310) is connected to the housing (121, 221), the breather valve (340) is connected to the electronic control housing (310), and the breather valve (340) communicates with the inside and the outside of the electronic control housing (310).

12. A hydraulic energy supply device (600), applied to an active suspension, wherein the hydraulic energy supply device (600) comprises the motor assembly (700) according to any one of claims 1 to 11.

13. A hydraulic energy supply device (600), wherein
the hydraulic energy supply device (600) further comprises a first hydraulic pump (110), a second hydraulic pump (210), and a motor assembly (700); and
the motor assembly (700) is the motor assembly (700) according to any one of claims 6 to 11, the two motors (120, 220) are respectively denoted as a first motor (120) and a second motor (220), the first motor (120) is connected to the first hydraulic pump (110) and adapted to drive the first hydraulic pump (110), and the second motor (220) is connected to the second hydraulic pump (210) and adapted to drive the second hydraulic pump (210).

14. The hydraulic energy supply device (600) according to claim 13, wherein the housings (121, 221) of the two motors (120, 220) are respectively denoted as a first housing (121) and a second housing (221), the first housing (121) is connected to the second housing (221), the first hydraulic pump (110) is disposed at an end portion of the first housing (121) away from the second housing (221), and the second hydraulic pump (210) is disposed at an end portion of the second housing (221) away from the first housing (121).

15. A chassis system, wherein the chassis system comprises:
a shock absorber; and
the hydraulic energy supply device (600) according to any one of claims 12 to 14, the hydraulic energy supply device (600) being in fluid communication with the shock absorber.

16. A vehicle, wherein the vehicle comprises the motor assembly (700) according to any one of claims 1 to 11, or the hydraulic energy supply device (600) according to any one of claims 12 to 14, or the chassis system according to claim 15.

17. The vehicle according to claim 16, wherein
the motor assembly (700) comprises:
a first motor (120);
a second motor (220);
a first flow channel (121o), the first flow channel (121o) being disposed on the first motor (120); and
a second flow channel (221o), the second flow channel (221o) being disposed on the second motor (220),
the vehicle further comprising an air conditioner, and the air conditioner being in fluid communication with the first flow channel (121o) and/or the second flow channel (221o).
